# EUROPÄISCHE PATENTSCHRIFT

(11) **EP 3 611 710 B1**
(45) Veröffentlichungstag und Bekanntmachung des Hinweises auf die Patenterteilung: **24.04.2024**
(21) Anmeldenummer: 19191392.0
(22) Anmeldetag: 13.08.2019
(51) Int. Cl.: G08G 1/01, G01C 21/34, G08G 1/0968, G08G 1/082

(54) **VERKEHRSFLUSSSIMULATOR**
TRAFFIC FLOW SIMULATOR
SIMULATEUR DE FLUX DE LA CIRCULATION

(30) Priorität: 15.08.2018 EP 18189134
(43) Veröffentlichungstag der Anmeldung: 19.02.2020
(73) Patentinhaber: Bernet, Aurelius, 8006 Zürich (CH)
(72) Erfinder: Bernet, Aurelius, 8006 Zürich (CH)
(74) Vertreter: Frei Patent Attorneys

(56) Entgegenhaltungen:
- DE-A1-102013 204 424
- DE-B3-102015 226 224
- US-A1- 2014 114 885

## Beschreibung

Die Erfindung bezieht sich auf das Gebiet der Simulation von Verkehrsflüssen und insbesondere auf ein Verfahren, ein Datenverarbeitungssystem und ein Computerprogramm zur Verkehrsflussimulation gemäss dem Oberbegriff der entsprechenden unabhängigen Patentansprüche.

Verkehrsflussanalysen können auf verschiedenen Größenordnungen stattfinden. Dazu bestehen verschiedene Verkehrsmodelle, die auf unterschiedlichen Ansätzen beruhen und auf verschiedene Größenordnungen von Verkehrssystemen angewendet werden. Im Folgenden werden diese herkömmlichen Verkehrsmodelle auf mikroskopischer, makroskopischer und mesoskopischer Ebene besprochen.

Allen herkömmlichen Verkehrsmodellen oder Verkehrssimulationen ist gemeinsam, dass sie für Aussagen auf Statistiken von Verkehrszählungen angewiesen sind. Die Resultate der herkömmlichen Verkehrssimulationen beziehen sich somit immer auf eine Vergangenheit.

Eine der Problematiken der herkömmlichen Verkehrssimulationen sind die Aufteilungen des Verkehrs an Strassenkreuzungen oder Strassengabelungen. Die Aufteilungen werden aufgrund von Annahmen getroffen. Zur Hilfe dieser Annahmen dienen Statistiken der Verkehrszählungen. Da sich Verkehrsnetzte ständig ändern, sei es durch die Veränderung einer Stadt oder die Veränderung durch Strassenbaustellen, hinken die Annahmen immer der Zeit hinterher. Werden herkömmliche Verkehrssimulationen auf grosse Verkehrsnetze angewendet, sind die Resultate immer verzerrt.

### Mikroskopische Ebene

In diesem Verkehrsmodell werden die Fahrzeuge einzeln betrachtet. Die einzelnen Fahrzeuge werden als Agenten modelliert, die ein bestimmtes Beschleunigungs-, Geschwindigkeit- und Bremsverhalten haben. Ein Agent in einem Softwaresystem besteht aus Gleichungen, welche das Verhalten eines einzelnen Individuums, in diesem Falle ein Verkehrsteilnehmer, wiedergeben. Bei diesen Modellen wird von agentenbasierten Verkehrsmodellen gesprochen.

Im Gegensatz zu anderen Arten der Verkehrsmodellierung besteht die agentenbasierte Modellierung aus vielen einzelnen Verkehrsteilnehmern, die als einzelne Einheiten Entscheidungs- oder Handlungsmöglichkeiten haben. Das Systemverhalten resultiert aus dem Verhalten der einzelnen Agenten.

Mit diesen Modellen lassen sich Aussagen treffen, zum Beispiel wie sich Staubildungen ergeben auf Grund von bestimmten Verhalten der Verkehrsteilnehmer. Diese Art der Verkehrsmodellierung kommt vor allem dann zur Anwendung, wenn der Fokus einer Fragestellung auf einem begrenzten Raum liegt.

### Makroskopische Ebene

In Analogie zu Modellen der Strömungslehre werden für Fahrzeugdichten oder Durchschnittsgeschwindigkeiten partielle Differentialgleichungen verwendet. Für diese Verkehrssimulationen werden Verkehrsmodelle mit Quellen und Senken aufgebaut. Quellen sind Orte, wo der Verkehr in das Verkehrsmodell eingespeist wird. Senken sind Orte im Verkehrsmodell, wo der Verkehr wieder aus dem Verkehrsmodell entnommen wird. Jede Quelle ist einer Senke zugeordnet. Die Verkehrszahlen welche für die Quellen und Senken, beziehungsweise der eingespeiste oder wieder entnommene Verkehr, beruhen auf Statistiken von Verkehrszählungen, also auf historischen Daten.

Die Basis eines hierfür verwendeten Verkehrsmodells besteht aus einem mathematischen Graphen, der aus Kanten und Knoten besteht. Die Quellen und Senken liegen auf Knoten. Um auf den Wegen von einer Quelle zu einer Senke, den Verkehrsfluss, Fahrzeugdichten oder Durchschnittsgeschwindigkeiten berechnen zu können, werden die partiellen Differentialgleichungen aus der Strömungslehre verwendet. Diese Berechnungen sind für lineare Gleichungen weitgehend erforscht, weisen aber für nichtlineare Gleichungen viele Lücken auf.

### Mesoskopische Ebene

Bei diesen Verkehrsflussmodellen kommen mikroskopische und makroskopische Modelle zum Einsatz. Die makroskopischen Modelle bilden den Verkehr nur in seiner Masse ab, einzelne Fahrer/Fahrzeug-Einheiten werden nicht betrachtet. Diese Modelle erlauben Aussagen über den Verkehrsfluss und die Verkehrsdichte. Die mikroskopischen Verkehrsflussmodelle erlauben die Betrachtung auf die einzelnen Fahrer/Fahrzeug-Einheiten und können Aussagen über den Verkehrszustand geben.

Anwendungsgebiete dieser Modelle sind zum Beispiel Aussagen über Staubildungen in großen Verkehrsnetzen wie dem Autobahnnetz. Die Aussagen lassen sich aber auch hier nur immer aufgrund von Statistiken des Verkehrsaufkommens treffen, also wiederum auf historischen Daten.

Verkehrsanalysen aufbauend auf diesen herkömmlichen Verkehrsmodellen zeigen somit immer nur die Vergangenheit oder die unmittelbare Vergangenheit.

DE 10 2015 226 224 B3 beschreibt ein Verfahren zur Ermittlung der Verkehrsbelastung in einem Verkehrsnetz, als Grundlage für eine Routenplanung. Die Verkehrsbelastung wird in einer Simulation iterativ ermittelt, indem zuerst ein prozentualer Anteil eines Verkehrsstromes von Startpunkten zu Zielpunkten über Routen kürzester Fahrzeit geroutet wird, und anschliessend weitere Anteile geroutet werden, wobei beim Routing eines Anteils jeweils die Auslastung des simulierten Verkehrsnetzes durch die bereits gerouteten Anteile berücksichtigt wird. Gemäss DE 10 2015 226 224 B3 soll die Güte des Verfahrens verbessert werden, indem nach dem Routen aller Anteile jeweils einzelne Anteile wieder aus dem Verkehrsnetz entfernt und ein zweites Mal geroutet werden.

DE 10 2013 204 424 A1 beschreibt eine automatische Generierung eines Verkehrsaufkommens für eine Simulation, bei welcher Gebäude mit unterschiedlichen Belegungsprofilen modelliert werden, woraus Zu-und Abflüsse eines Verkehrsnetzes generiert werden.

US 2014/0114885 A1 beschreibt ein Verfahren zur Schätzung einer Verkehrsdichte anhand von Messdaten, welches ein System zum maschinellen Lernen benutzt.

Es ist deshalb Aufgabe der Erfindung, ein Verfahren, ein Datenverarbeitungssystem und ein Computerprogramm zur Verkehrsflussimulation der eingangs genannten Art zu schaffen, welche Alternativen zu den oben beschriebenen Ansätzen bieten.

Diese Aufgabe lösen ein Verfahren, ein Datenverarbeitungssystem und ein Computerprogramm zur Verkehrsflussimulation mit den Merkmalen der entsprechenden unabhängigen Patentansprüche.

Es findet also zur Bestimmung der Aufenthaltsanteile in den Wegabschnitten eine Iteration über die Startorte, die Verkehrsteilnehmer und deren Bruchteile, sowie über die Zielorte und die Wegabschnitte statt. Die Bestimmung der Belastung summiert also die Aufenthaltsanteile von jedem der optimalen Wege von jedem der Startorte zu jedem der Zielorte.

Der optimale Weg kann gemäss an sich bekannten Verfahren nach Massgabe von vorgebbaren Optimierungskriterien bestimmt werden. Solche Kriterien sind bsw. kürzester Weg, kürzeste Fahrzeit, geringster Energieverbrauch, ... etc.

Es ist unbestimmt, zu welchem Zielort ein Verkehrsteilnehmer von seinem Startort fährt, weshalb im neuen Verfahren zur Verkehrssimulation eine Streuung angewendet wird. Jeder einzelne Verkehrsteilnehmer von einem Startort wird durch die Anzahl möglicher Zielorte geteilt und ein entsprechender Verkehrsteilnehmerbruchteil über die optimalen, insbesondere kürzesten, Wege zu allen möglichen Zielorten gestreut. Es sind also jedem Startort mehrere Zielorte zugeordnet. Es ist nicht vorgegeben, zu welchem Zielort ein bestimmter Verkehrsteilnehmer fährt. Im Gegensatz zu herkömmlichen Verfahren wird somit auch keine Quelle-Ziel-Matrix (Origin-Destination Matrix) vorgegeben und verwendet.

Jeder Verkehrsteilnehmerbruchteil ist also einem Zielort zugeordnet, und ebenso ist jeder der optimalen Wege einem Zielort zugeordnet. Somit ist - über den Zielort - auch jedem optimalen Weg ein Verkehrsteilnehmerbruchteil zugeordnet.

Eine Gesamtzahl der Verkehrsteilnehmer der Startorte kann aus einer urbanen Statistik vorgegeben werden. Die aus dem Verfahren resultierenden Verkehrsströme werden also aus urbanen Statistiken generiert und nicht aus Verkehrsstatistiken! Urbane Statistiken repräsentieren beispielsweise Bevölkerungszahlen, Nutzflächen von Gebäuden für Wohnen, Einkaufsmöglichkeiten, Arbeitsplätze, kulturelle Einrichtungen etc. Sie definieren für jeden der Gesamtzahl von Verkehrteilnehmern jeweils einen Startort sowie mehrere Zielorte, auf die der Verkehrsteilnehmer aufgeteilt wird.

Gemäss der beanspruchten Erfindung ist es der Fall, dass der einem bestimmten Zielort zugeordnete Verkehrsteilnehmerbruchteil jeweils gleich einem diesem Zielort zugeordneten Zielgewichtungsfaktor, dividiert durch die Anzahl der Zielorte, ist.

In einer Ausführungsform ist der Verkehrsteilnehmerbruchteil jeweils gleich einem dem Zielort zugeordneten Zielgewichtungsfaktor, dividiert durch die Anzahl der Zielorte.

Gemäss Ausführungsformen ist es der Fall, dass der Verkehrsteilnehmerbruchteil jeweils gleich eins dividiert durch die Anzahl der Zielorte ist.

Beispielsweise ist der Zielgewichtungsfaktor eins, d.h. alle Ziele werden als gleich wichtig betrachtet. In dieser Ausführungsform ist der Verkehrsteilnehmerbruchteil jeweils gleich eins dividiert durch die Anzahl der Zielorte.

Gemäss Ausführungsformen ist es der Fall, dass der Aufenthaltsanteil des Verkehrsteilnehmers im Wegabschnitt als Funktion des Verkehrsteilnehmerbruchteiles bestimmt wird, indem der Aufenthaltsanteil als Funktion des Verkehrsteilnehmerbruchteils und einer Abschnittslänge des Wegabschnitts bestimmt wird.

Gemäss Ausführungsformen ist es der Fall, dass der Aufenthaltsanteil des Verkehrsteilnehmers im Wegabschnitt als Produkt des Verkehrsteilnehmerbruchteils und der Abschnittslänge, dividiert durch die Länge des zugeordneten optimalen Wegs, bestimmt wird.

Gemäss Ausführungsformen wird der Aufenthaltsanteil des Verkehrsteilnehmers im Wegabschnitt als Funktion des Verkehrsteilnehmerbruchteiles bestimmt, indem der Aufenthaltsanteil gleich dem Verkehrsteilnehmerbruchteil gesetzt wird. Dies entspricht einer Situation, in welcher alle Abschnittslängen als gleich lang betrachtet werden.

Gemäss Ausführungsformen ist es der Fall, dass jeweils beim Bestimmen eines optimalen Wegs eine bereits vorhandene Belastung der Wegabschnitte berücksichtigt wird, insbesondere indem in jedem Wegabschnitt diese Belastung mit einer Abschnittskapazität des Wegabschnitts verglichen wird.

Dazu kann so vorgegangen werden, dass bei der Iteration über die die Startorte, die Verkehrsteilnehmer und Bruchteile der Verkehrsteilnehmer, sowie über die Zielorte und die Wegabschnitte - jeweils während der Iteration - die Aufenthaltsanteile in den Wegabschnitten laufend aufsummiert werden. Wenn in einem der Wegabschnitte die Summe der Aufenthaltsanteile im Verhältnis zur Abschnittskapazität zu gross wird, wird dies bei weiteren Iterationen bei der Bestimmung der jeweiligen optimalen Wege berücksichtigt.

Gemäss Ausführungsformen ist es der Fall, dass die folgenden Schritte für eine Kalibrierung der Simulation durchgeführt werden:
- Messen mindestens eines realen Verkehrsflusses, wobei jeder reale Verkehrsfluss einem realen Messungs-Wegabschnitt zugeordnet ist und in diesem gemessen wird;
- Berechnen eines Kalibrierungsfaktors anhand des mindestens einen realen Verkehrsflusses und der in der Simulation bestimmten Belastung respektive Belastungen der Wegabschnitte, welche den realen Messungs-Wegabschnitten entsprechen;
- Berechnen einer kalibrierten Belastung der übrigen Wegabschnitte nach Massgabe des Kalibrierungsfakores.

Dieses Vorgehen erlaubt es, eine kleinere Anzahl von Verkehrsteilnehmern in der Verkehrsflusssimulation einzusetzen, als in der Realität auftreten werden. Bei der Simulation von grossen Städten mit vielen Verkehrsteilnehmern reduziert sich dadurch der Rechenaufwand. Die Kalibrierung kann im einfachsten Fall durch Multiplikation der Belastungen der Wegabschnitte (welche ja jeweils eine Summe von Aufenthaltsanteilen von Verkehrsteilnehmern sind) mit dem Kalibrierungsfaktor geschehen.

Gemäss Ausführungsformen ist es der Fall, dass
- bei der Iteration für jeden Startort und für jeden der N_Si Verkehrsteilnehmer des Startorts jeweils eine Startzeit vorgebbar ist;
- daraus jeweils eine Zeitinformation bestimmt wird, welche jedem der Aufenthaltsanteile des Verkehrsteilnehmers in den Wegabschnitten zugeordnet ist; und
- die Summation der Aufenthaltsanteile aller Verkehrsteilnehmer in einem Wegabschnitt unter Berücksichtigung der jeweiligen Zeitinformationen geschieht.

Die Zeitinformation kann beispielsweise ein Zeitpunkt oder ein Zeitintervall sein, zu resp. in welchem der Aufenthaltsanteil des Verkehrsteilnehmers im Wegabschnitt vorliegt. Die Summation der Aufenthaltsanteile unter Berücksichtigung der jeweiligen Zeitinformationen kann beispielsweise die Aufenthaltsanteile jeweils für unterschiedliche Zeitintervalle einzeln summieren. Damit ist eine Verteilung der Aufenthaltsanteile über die Zeit ermittelbar.

In Ausführungsformen ist die Zeitinformation für alle Aufenthaltsanteile eines Verkehrsteilnehmers dieselbe. Das bedeutet, dass in einer Simulation eines zeitlichen Ablaufs alle Aufenthaltsanteile eines Verkehrsteilnehmers gleichzeitig, also zum selben Zeitpunkt einer Simulationszeit, im Netz erscheinen.

Dies ist im Gegensatz zu herkömmlichen, z.B. agentenbasierten Verfahren, in welchen der Weg eines Verkehrsteilnehmers im Netz über die Zeit nachgebildet wird, also der Standort des Verkehrsteilnehmers sich mit der (simulierten) Zeit respektive Simulationszeit ändert, indem er sich durch das Netz bewegt.

Die Berücksichtigung der jeweiligen Zeitinformationen kann dadurch geschehen, dass Aufenthaltsanteile eines Verkehrsteilnehmers nach Ablauf einer bestimmten Verweilzeit zu der Summation der Aufenthaltsanteile nicht mehr beitragen.

Sie kann auch dadurch geschehen, dass sie bei zunehmender Verweilzeit - von der Startzeit aus betrachtet - entsprechend einem vorgegebenen Verlauf in Funktion der Verweilzeit zu der Summation der Aufenthaltsanteile beitragen. Die Funktion kann stetig sein oder Sprünge aufweisen. Beispielsweise kann der Beitrag zur der Summation mit Null beginnen, mit zunehmender Verweilzeit bis zum Wert des Aufenthaltsanteils zunehmen, und dann wieder auf Null abnehmen. Oder der Beitrag kann mit dem Wert des Aufenthaltsanteils beginnen und mit zunehmender Verweilzeit auf Null abnehmen. Auch hier gilt: In allen Fällen kann die zeitliche Variation eines Aufenthaltsanteils gleichzeitig für alle Aufenthaltsanteile eines Verkehrsteilnehmers geschehen.

In entsprechenden Ausführungsformen ist ein zeitlicher Verlauf einer Variation eines Beitrags der Aufenthaltsanteile eines Verkehrsteilnehmers bei der Summation der Aufenthaltsanteile in den Wegabschnitten derselbe.

Indem die Beiträge der einzelnen Verkehrsteilnehmer im Verlauf der Simulationszeit jeweils zu unterschiedlichen Zeiten vorliegen, ergibt sich ein (simulierter) Verlauf der gesamten Belastung der Wegabschnitte über die Zeit, typischerweise über einen Tag. Die Qualtität und Aussagekraft dieser Belastungen respektive ihres zeitlichen Verlaufes ist hoch, obschon die verteilten Beiträge eines einzelnen Verkehrsteilnehmers, d.h. seiner Verkehrsteilnehmerbruchteile, in allen Wegabschnitten gleichzeitig beitragen respektive nicht beitragen.

Es wird also - im Gegensatz zu einem agentenbasierten System - in solchen Ausführungsformen keine Fahrt eines Verkehrsteilnehmers durch das Netz simuliert, wobei der Verkehrsteilnehmer zu verschiedenen Zeiten in verschiedenen Wegabschnitten befindet, sonderen während einer bestimmten Zeitdauer liegen alle Verkehrsteilnehmerbruchteile des Verkehrsteilnehmers in allen betroffenen Wegabschnitten der optimalen Wege zu allen Zielorten vor (und werden summiert), und ausserhalb dieser Zeitdauer liegen sie nicht vor.

Der simulierte Verlauf geht jeweils von einer aktuellen Topologie des Verkehrsnetzes aus. Bestimmte Parameter, welche von der Topologie im Wesentlichen unabhängig sind, können durch Abgleich von Simulationen mit Messungen, beispielsweise Verkehrsflussmessungen, mittels Optimierungsverfahren bestimmt werden. Somit kann mit dem hier gezeigten Verfahren zur Verkehrsflusssimulation eine prädiktive, also zukunftsgerichtete Simulation der Verkehrsflüsse vorgenommen werden, für eine aktuelle Toplogie, welche von der Topologie abweicht, bei welcher die Messungen vorgenommen wurden. Dies ist ein wesentlicher Unterschied zur Verwendung von Messungen respektive historischen Daten für einen Tagesverlauf, da diese historischen Daten Änderungen in der Topologie nicht berücksichtigen können.

Ausgehend von der prädiktiven Simulation anhand der aktuellen Topologie kann über einen Tagesverlauf hinweg eine Steuerung von Verkehrsleitmitteln und/oder von einzelnen Verkehrsteilnehmern realisiert werden.

In Ausführungsformen weist das Verfahren die folgenden Schritte zur Bestimmung von Startzeiten der Verkehrsteilnehmer auf:
- Messen von zeitlichen Verläufen von realen Verkehrsflüssen, wobei jeder reale Verkehrsfluss einem realen Messungs-Wegabschnitt zugeordnet ist und in diesem gemessen wird;
- Durchführen eines Optimierungsverfahrens mit iterativ wiederholter Durchführung der Bestimmung der Belastung von Wegabschnitten, wobei die Startzeiten der Verkehrsteilnehmer variiert werden, um zeitliche Verläufe der Belastung von Wegabschnitten, welche den realen Messungs-Wegabschnitten entsprechen, den zeitlichen Verläufen der realen Verkehrsflüsse möglichst gut anzunähern.

Damit ist es möglich, den zeitlichen Verlauf der Startzeiten und damit die Variation der simulierten Belastungen im Verkehrsnetz der Realität anzunähern. Beispielsweise werden die Startzeiten respektive deren zeitliche Verteilung, einmal, anhand der Messungen in einer bestimmten Topologie des Verkehrsnetzes, in der oben beschriebenen Weise bestimmt. Dann werden sie auch bei veränderter Topologie - beispielsweise durch Baustellen - bei der Verkehrsflusssimulation eingesetzt.

Beim Durchführen des Optimierungsverfahrens werden die Startzeiten der Verkehrsteilnehmer variiert, wobei die Summe der Verkehrsteilnehmer gleich bleibt. Beispielsweise wird eine Anzahl von Verkehrsteilnehmern einem späteren Startzeitpunkt respektive Zeitfenster zugeordnet, um eine Verschiebung des Verkehrsaufkommens zu einem späteren Zeitpunkt hin zu bewirken. Die Summe ist in der Regel durch die bereits genannten urbanen Statistiken vorgegeben.

In Ausführungsformen geschieht die Optimierung in gleicher Weise, jedoch sind die Verkehrsteilnehmer jeweils verschiedenen Verkehrsarten zugeordnet. Es sind dazu mindestens zwei Verkehrsarten definiert. Jede Verkehrsart weist eine zugeordnete Menge von Startorten und Zielorten auf. Eine Verkehrsart entspricht beispielsweise einem Pendlerverkehr, Einkaufsverkehr, Arbeitsverkehr, Schulverkehr, Logistikverkehr, Feierabendverkehr, etc. Bei jeder Verkehrsart lassen sich eine Hinreise und eine Rückreise unterscheiden.

In Ausführungsformen weist das Verfahren die folgenden Schritte zur Bestimmung von identifizierten Startzeitverteilungen und/oder Verkehrsaufkommen der verschiedenen Verkehrsarten auf:
- Durchführen eines Optimierungsverfahrens mit iterativ wiederholter Durchführung der Bestimmung der Belastung von Wegabschnitten im Modell des Verkehrsnetzes, wobei die Startzeitverteilungen und/oder die Verkehrsaufkommen aller Verkehrsarten (*V1*, *V2,* ...) variiert werden, um zeitliche Verläufe der Belastung von Wegabschnitten (3), welche den realen Messungs-Wegabschnitten entsprechen, den gemessenen zeitlichen Verläufen optimal anzunähern;
- Bestimmung der identifizierten Startzeitverteilungen und/oder Verkehrsaufkommen als jene, welche zu dieser optimalen Annäherung führen.

Das Ergebnis des Optimierungsverfahrens - die zeitliche Verteilung der Startzeiten - enthält somit auch eine Differenzierung über die verschiedenen Verkehrsarten.

Damit wiederum kann für jedem Wegabschnitt bestimmt werden, wieviel die einzelnen Verkehrsarten zu seiner Belastung beitragen. Anhand von punktuellen Messungen der Verkehrsflüsse, also der Gesamtbelastung einzelner Wegabschnitte, und der Information über die geographische Verteilung von Start- und Zielorten jeweils eine Menge von Verkehrsteilnehmern (aus urbanen Statistiken) lässt sich also der Beitrag einer bestimmten Verkehrsart zur Belastung eines bestimmten Wegabschnitts bestimmen, und insbesondere auch die zeitliche Veränderung dieses Beitrags, beispielsweise im Tagesverlauf.

In Ausführungsformen wird anstelle der oben beschriebenen Optimierung ein System zum maschinellen Lernen eingesetzt. Das entsprechende Verfahren weist die folgenden Schritte zur Bestimmung von identifizierten Startzeitverteilungen und/oder Verkehrsaufkommen der verschiedenen Verkehrsarten auf:
- Trainieren eines Systems zum maschinellen Lernen mit mehreren Sätzen mit Kombinationen von Startzeitverteilungen und/oder Verkehrsaufkommen der verschiedenen Verkehrsarten, wobei jedem dieser Sätze ein Satz von zeitlichen Verläufen der Belastung von Wegabschnitten im Modell des Verkehrsnetzes zugeordnet ist, wobei diese Wegabschnitte im Modell des Verkehrsnetzes den realen Messungs-Wegabschnitten entsprechen;
- Bestimmung der identifizierten Startzeitverteilungen und/oder Verkehrsaufkommen durch das trainierte System zum maschinellen Lernen aus den gemessenen zeitlichen Verläufen.

Das lernende System lernt also eine Zuordnung zwischen der zeitliche Verteilung der einzelnen Verkehrsarten und dem totalen Verkehrsaufkommen an mehreren Messstellen, und bestimmt anschliessend aufgrund von Messungen des totalen Verkehrsaufkommens die zeitliche Verteilung der einzelnen Verkehrsarten.

Das Verfahren, sei es mittels der oben beschriebenen Optimierung oder mittels des Systems zum maschinellen Lernen, dient damit als Messverfahren zur Bestimmung der zeitlichen Verteilung der Anteile von unterschiedlichen Verkehrsarten, wobei die Verkehrsarten durch unterschiedliche Startorte und Zielorte charakterisiert sind.

Diese zeitliche Verteilung ändert sich - für ein bestimmtes Szenario - vergleichsweise langsam, d.h. sie bleibt über mehrere Tage, Wochen oder Monate gleich. Anhand dieser zeitlichen Verteilung kann mit einem Verkehrsnetz, welches einen aktuellen Zustand repräsentiert, eine prädiktive Simulation durchgeführt werden.

Ein Szenario oder Verkehrsszenario betrifft einen Tagesverlauf des Verkehrs, und ist definiert durch eine bestimmte
- Startortanzahl von Verkehrsteilnehmern,
- deren Zielorte,
- die Zuordnung der Verkehrsteilnehmer zu jeweils einer Verkehrsart,
- die Startzeiten der Verkehrsteilnehmer im Tagesverlauf.

Szenarien entsprechen beispielsweise einem Arbeitstag, einem Samstag, Sonntag, Arbeitstag mit Feiertag im Nachbarkanton, etc. Verkehrsszenarien können ferner auch nach anderen Parametern wie Jahreszeit, Wetter etc. differenziert werden. Es können - müssen aber nicht - bei der Bestimmung der zeitlichen Verteilung der Anteile der Verkehrsarten solche Parameter, welche ein Verkehrsszenario charakterisieren, erfasst werden, und bei der prädiktiven Simulation in einer bestimmten Situation jeweils die Verteilungen aus einem passenden Szenario verwendet werden.

In Ausführungsformen sind somit mindestens zwei Verkehrsarten (*V1*, *V2,* ...) definiert, und weist jede Verkehrsart (*V1*, *V2*, ...) eine der Verkehrsart zugeordnete Menge von Startorten (*Mₛₜₐᵣₜ(V)*) auf und eine der Verkehrsart zugeordnete Menge von Zielorten (*M_{Ziel}(V)*) auf. Jeder Verkehrsteilnehmer ist einer Verkehrsart zugeordnet, sowie einem Startort und mehreren Zielorten. Das Verfahren weist die folgenden weiteren Schritte auf:
- Messen von zeitlichen Verläufen von realen Verkehrsflüssen, wobei jeder reale Verkehrsfluss einem realen Messungs-Wegabschnitt in einem realen Verkehrssystem zugeordnet ist und in diesem gemessen wird,
- Bestimmung von identifizierten Startzeitverteilungen und/oder Verkehrsaufkommen der verschiedenen Verkehrsarten anhand der gemessenen zeitlichen Verläufe und eines Modells des Verkehrsnetzes mit der gleichen Topologie wie das reale Verkehrssystem;
- Bilden eines geänderten Modells des Verkehrsnetzes durch Anpassen der Topologie nach Massgabe von Änderungen im realen Verkehrssystem;
- Bestimmung der Belastung von Wegabschnitten im geänderten Modell des Verkehrsnetzes unter Verwendung der identifizierten Startzeitverteilungen und/oder Verkehrsaufkommen der verschiedenen Verkehrsarten.

Wie oben schon erwähnt, kann ausgehend von der prädiktiven Simulation anhand der aktuellen Topologie über einen Tagesverlauf hinweg eine Steuerung von Verkehrsleitmitteln realisiert werden. Gemäss Ausführungsformen geschieht dabei eine Steuerung von Verkehrsleitmitteln, insbesondere Verkehrsampeln, nach Massgabe der Belastungen der Wegabschnitte. Dabei können beispielsweise Verkehrsflüsse aus relativ höher belasteten Wegabschnitten gegenüber weniger belasteten Wegabschnitten bevorzugt werden. Alternativ oder zusätzlich geschieht eine Steuerung von Navigationsgeräten in Fahrzeugen nach Massgabe der Belastungen der Wegabschnitte.

In Ausführungsformen weist das Verfahren die folgenden Schritte auf:
- Bestimmen mindestens einer belasteten Route als zusammenhängende Menge von in einer Bewegungsrichtung aufeinanderfolgenden Wegabschnitten, deren Belastung ein bestimmtes Mass überschreitet;
   und mindestens einen der Schritte
- Schalten, während einer vorgegebenen Grünintervallzeit, aller Ampeln in der belasteten Route auf Grün;
- Eingriff in die Steuerung von Fahrzeugen in belasteten Routen.

Ein Eingriff in die Steuerung kann auf verschiedenen Stufen erfolgen, z.B. als Geschwindigkeitsempfehlung an den Fahrer oder als direkte Beeinflussung der Fahrzeuggeschwindigkeit.

Dabei werden Wegabschnitte gemäss Bewegungsrichtung getrennt betrachtet. Das heisst, dass das Bestimmen, welche Wegabschnitte einer belasteten Route zugehören und/oder das Schalten der Ampeln, jeweils für die beiden Bewegungsrichtungen getrennt vorgenommen werden. Dies kann geschehen, indem Wegabschnitte entlang derselben Kante aber in entgegengesetzte Richtungen als separate Wegabschnitte modelliert werden und ihre Belastung separat modelliert wird.

Das Bestimmen von belasteten Routen kann zu verschiedenen Simulationszeiten im Verkehrsnetz wiederholt ausgeführt werden. Dadurch ergeben sich je nach simulierter Tageszeit unterschiedliche belastete Wegabschnitte. Dem entsprechend kann die Schaltung der Ampeln im Tagesverlauf variieren.

In Ausführungsformen besteht eine belastete Route aus einer Folge von Wegabschnitten die in Bewegungsrichtung aufeinander folgen. An einer Eingangsseite eines belasteten Wegabschnittes können zwei oder mehr belastete Wegabschnitte in diesen einmünden. An einer Ausgangsseite eines belasteten Wegabschnittes kann dieser sich in zwei oder mehr aufteilen.

Die anhand der oben beschriebenen Bestimmung der Zuordnung der Verkehrsteilnehmer zu verschiedenen Verkehrsarten lässt sich eine gezielte Steuerung der Verkehrsleitmittel realisieren: diese Zuordnung variiert über die Zeit, typischerweise im Tagesverlauf. Anschaulich und vereinfacht kann sich beispielsweise ergeben, dass eine bestimmte Kreuzung durch den morgendlichen Pendlerverkehr mehrheitlich von Norden nach Süden durchfahren wird, und durch den späteren Einkaufsverkehr von Osten nach Westen. Belastete Wegabschnitte ändern sich also im Tagesverlauf. Änderungen dieser Art können bei der oben beschriebenen Steuerung von Verkehrsleitmitteln berücksichtigt werden.

In Ausführungsformen kann somit beim Bestimmen der mindestens einen belasteten Route nur die Belastung durch eine Untermenge der verschiedenen Verkehrsarten berücksichtigt werden. Diese Untermenge umfasst nicht die Gesamtmenge der Verkehrsarten. Es kann insbesondere nur die Belastung durch eine einzige der Verkehrsarten berücksichtigt werden (z.B nur Pendlerverkehr, nur Shoppingverkehr). Damit können durch die Steuerung bestimmte Verkehrsarten bevorzugt werden.

Wenn die oben beschriebene Bestimmung der Startzeiten entsprechend der Zuordnung der Verkehrsteilnehmer zu den verschiedenen Verkehrsarten geschieht, ergibt sich automatisch auch die unterschiedliche Belastung entsprechend den unterschiedlichen Verkehrsarten über den Tagesverlauf.

Wie oben schon erwähnt, kann in Kombination mit der prädiktiven Simulation anhand der aktuellen Topologie über einen Tagesverlauf hinweg eine Steuerung von einzelnen Verkehrsteilnehmern realisiert werden. In Ausführungsformen weist das Verfahren dazu die folgenden Schritte auf:
- Empfangen eines Startortes und eines Zielortes eines realen Verkehrsteilnehmers;
- Bestimmen einer für diesen realen Verkehrsteilnehmer optimalen Route, unter Berücksichtigung von in der Zukunft liegenden Belastungen der Wegabschnitte des Verkehrsnetzes;
- Übermittlung von Navigationsanweisungen entsprechend dieser optimalen Route an diesen realen Verkehrsteilnehmer.

Damit wird es möglich, nicht nur eine Navigationshilfe für einen aktuellen Zustand des Verkehrsnetzes zu bieten, sondern anhand eines mittels der Verkehrsflussimulation ermittelten zukünftigen Zustandes.

Das Datenverarbeitungssystem zur Verkehrsflussimulation weist Speichermittel mit darin gespeicherten Computerprogrammcodemitteln auf, welche ein Computerprogramm beschreiben, und Datenverarbeitungsmittel zur Ausführung des Computerprogramms, wobei die Ausführung des Computerprogramms zur Durchführung des Verfahrens zur Verkehrsflussimulation führt.

Das Computerprogramm zur Verkehrsflussimulation ist in einen internen Speicher einer digitalen Datenverarbeitungseinheit ladbar und weist Computerprogrammcodemittel auf, welche, wenn sie in einer digitalen Datenverarbeitungseinheit ausgeführt werden, diese zur Ausführung des Verfahrens zur Verkehrsflussimulation bringen. In einer bevorzugten Ausführungsform der Erfindung weist ein Computerprogrammprodukt einen Datenträger, respektive ein computerlesbares Medium auf, auf welchem die Computerprogrammcodemittel gespeichert sind.

Aufbauend auf dem Datenverarbeitungssystem zur Verkehrsflussimulation können eine Vorrichtung zum Identifizieren von Startzeitverteilungen und/oder Verkehrsaufkommen verschiedener Verkehrsarten in einem realen Verkehrsnetz, und/oder eine Vorrichtung zur Steuerung von Verkehrsleitmitteln, insbesondere Verkehrsampeln und/oder eine Vorrichtung zur Steuerung von Navigationsgeräten in Fahrzeugen realisiert werden.

Weitere bevorzugte Ausführungsformen gehen aus den abhängigen Patentansprüchen hervor. Merkmale aus Vorrichtungsansprüchen sind mit Merkmalen aus Verfahrensansprüchen kombinierbar, und umgekehrt.

Im folgenden wird der Erfindungsgegenstand anhand von bevorzugten Ausführungsbeispielen, welche in den beiliegenden Zeichnungen dargestellt sind, näher erläutert. Es zeigen jeweils schematisch:
- Figuren 1-4: ein Verkehrsnetz und darauf abgebildete Elemente zur Erklärung des Verfahrens;
- Figuren 5-6: ein Verkehrsnetz in unterschiedlichen Zuständen;
- Figur 7: eine zeitliche Verteilung von Startzeiten und ein daraus resultierendes Verkehrsaufkommen;
- Figur 8: Verkehrsaufkommen verschiedener Verkehrsarten;
- Figur 9: ein Verkehrsnetz mit darübergelegtem Raster zur Erfassung von urbanen Statistiken;
- Figur 10: eine Überlagerung von verschiedenen Verkehrsarten an verschiedenen Zählstellen im Verkehrsnetz;
- Figur 11: entsprechende Tagesgangskurven; und
- Figuren 12-13: Abläufe zum Abgleichen eines Modells mit gemessenen Tagesgangskurven und zum Durchführen von prädiktiven Simulationen mit dem abgeglichenen Modell.

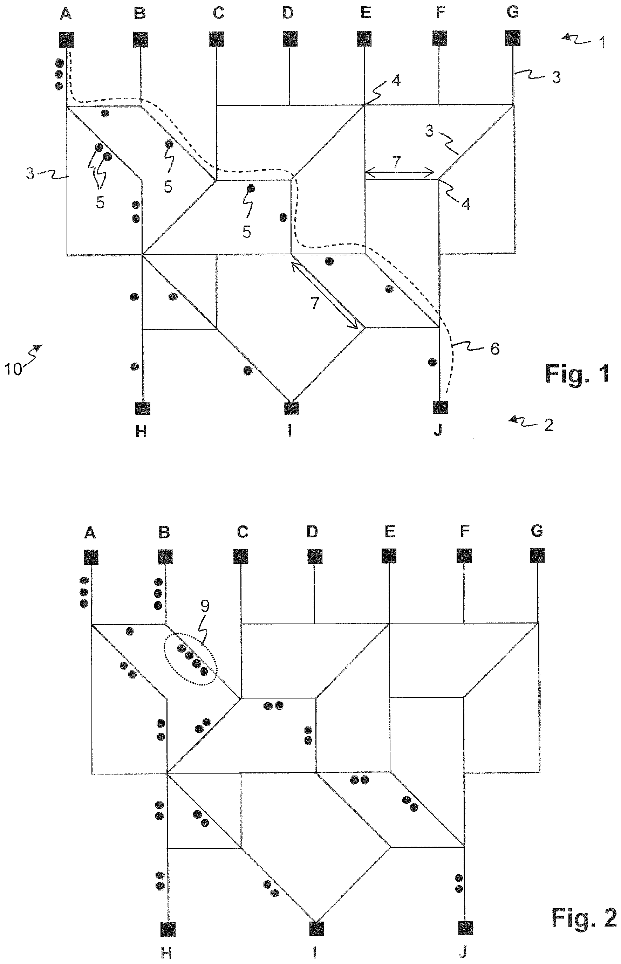

Im Verkehrsflusssimulator respektive im Verfahren zur Verkehrsflusssimulation werden die einzelnen Verkehrsteilnehmer in Verkehrsteilnehmerbruchteile geteilt und von ihrem Startort zu ihren Zielorten über das Verkehrsnetz verteilt oder gestreut. Die **Figur 1** zeigt die Teilung und Streuung eines Verkehrsteilnehmers von seinem Startort zu allen seinen möglichen Zielorten. Die weiteren Bilder zeigen nacheinander die weiteren Teilungen und Streuungen weiterer Verkehrsteilnehmer. **Figur** 1 zeigt ein Verkehrsnetz 10 mit Knoten 4 und Kanten, wobei Knoten Kreuzungen und die Kanten Wegabschnitten 3 entsprechen.

In der **Figur 1** wird als Beispiel ein Pendlerverkehr dargestellt, das heisst, der Verkehr von Wohnlokalitäten zu Arbeitsplätzen. Wohnlokalitäten (Startort A, B, C, D, E, F, G) werden in der weiteren Erklärung zusammenfassend als Startorte 1 benannt. Entsprechend werden die Arbeitsplätze (Zielorte H, J, I) in der weiteren Erklärung zusammenfassend als Zielorte 2 benannt. Die Figur zeigt die Startorte und Zielorte an dem Rändern des Verkehrsnetzes, um die Erklärung zu vereinfachen, in Realität können sie über das ganze Verkehrsnetz verteilt sein.

Die Verkehrsteilnehmer eines ersten Startorts A werden entsprechend der Anzahl aller Zielorte 2 geteilt und vom ersten Startort A über optimale Wege 6, beispielsweise die kürzesten Wege zu den einzelnen Zielorten 2 gestreut. Die Gesamtzahl oder Startoranzahl der Verkehrsteilnehmer N_ Si für jeden i-ten der Startorte 1 kann aus einer urbanen Statistik vorgegeben werden. Je nach Ziel der Simulation kann die Gesamtzahl gleich einer realen Anzahl von Verkehrsteilnehmern gesetzt werden, oder sie kann proportional zur realen gesetzt werden, mit dem gleichen Proportionalitätsfaktor für alle Startorte 1. Die Startortanzahl kann auch für jeden der Startorte 1 eins betragen, wenn allen Startorten 1 gleich viele Verkehrsteilnehmer zugeordnet sind.

Im aufgeführten Beispiel, in **Figur 1****,** wird ein einzelner Verkehrsteilnehmer durch die Anzahl Zielorte 2 geteilt. In diesem Beispiel durch drei, entsprechend der Anzahl Zielorte 2. Vom ersten Startort A wird jede Kante zum ersten Zielort H des Verkehrsnetzes mit einem Bruchteil des Verkehrsteilnehmers (Verkehrsteilnehmerbruchteil) markiert, in diesem Fall also mit einem Drittel des Verkehrsteilnehmers. Dasselbe Verfahren wird für den optimalen Weg 6, in diesem Fall dem kürzesten Weg vom ersten Startort A zum zweiten Zielort I durchgeführt. Das Verfahren wird, zur Vervollständigung ebenfalls für den kürzesten Weg vom ersten Startort A zum dritten Zielort J durchgeführt.

Im Beispiel in der **Figur 1** gibt es vom ersten Startort A drei optimale, in diesem Fall kürzeste Wege 6 zu den drei Zielorten 3. Ein Verkehrsteilnehmer des ersten Startorts A wird durch die Anzahl möglicher Zielorte 3 geteilt und über die drei optimalen Wege 6 zu den Zielorten 3 gestreut. Die Streuung ist in den Figuren durch runde Markierungen, entsprechend einem Aufenthaltsanteil 5 dargestellt. Dieser kann bei gleich langen Wegabschnitten 3 jeweils gleich einem Verkehrsteilnehmerbruchteil sein. Kanten respektive Wegabschnitte 3 können auf mehren Wegen liegen, weshalb sie auch mehrmals markiert werden können. Die erste Kante vom Startort A aus liegt auf allen drei kürzesten Wegen zu den drei Zielorten, weshalb sie dreimal markiert wurde. Kanten, bei denen sich die Wege nicht überlagern, sind nur einmal markiert. Kanten, wo sich zwei Wege überlagern, sind zweimal markiert. Die Wege von den Startorten zu den Zielorten können sich überlagern. Kanten, die auf überlagerten Wegen liegen, werden mehrmals markiert. Gemäss der Bewegungsrichtung der Verkehrsteilnehmer werden die Aufenthaltsanteile 5 jeweils in Bewegungsrichtung rechts von den Kanten angezeigt. Wegabschnitte 3 entlang derselben Kante aber in entgegengesetzte Richtungen können als separate Wegabschnitte 3 betrachtet und ihre Belastung separat modelliert werden. In anderen Ausführungsformen werden die Belastungen von Wegabschnitten 3 auf derselbern Kante ungeachtet der Bewegungsrichtung betrachtet und summiert.

In der **Figur 2** wird das Verfahren der Streuung auf den zweiten Startort fortgesetzt. Wieder werden die Verkehrsteilnehmer des Startortes B entsprechend der Anzahl der Zielorte geteilt und über die kürzesten Wege vom Startort B zu allen Zielorten gestreut. Die Streuung vom Startort A zu allen Zielorten und die Streuung vom Startort B zu allen Zielorten überlagern sich auf Kanten die auf gemeinsamen Wegen liegen.

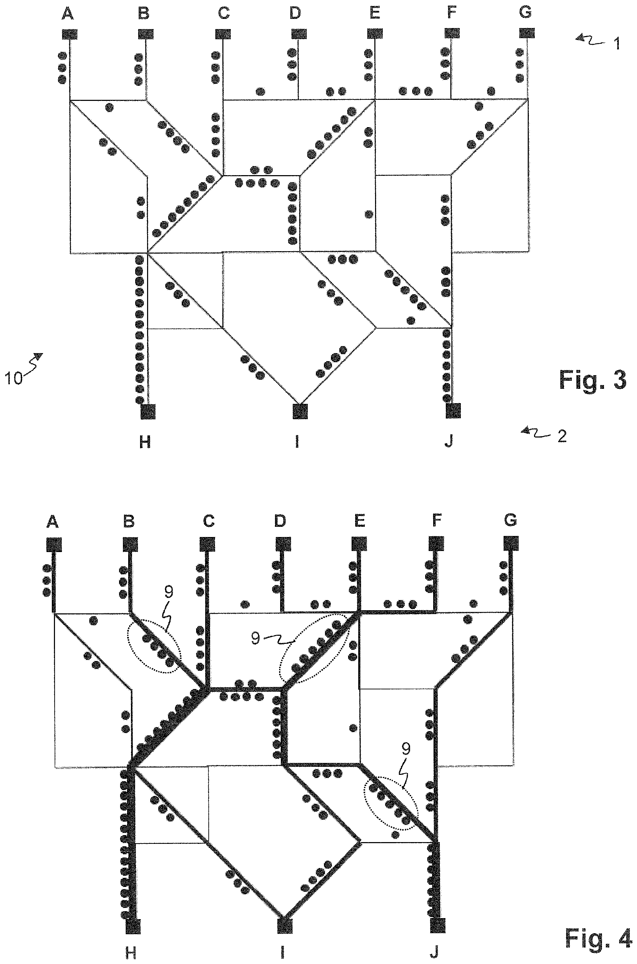

In **Figur 3** wird das Verfahren der Streuung auf alle weiteren Startorte fortgesetzt. Jeder einzelne Verkehrsteilnehmer der Startorte wird entsprechend der Anzahl der Zielorte geteilt und über die kürzesten Wege von den Startorten zu den Zielorten gestreut. Die Streuungen von allen Startorten zu allen Zielorten, und damit die Aufenthaltsanteile 5 überlagern sich auf den Kanten, die auf gemeinsamen Wegen liegen.

Ist das Verfahren der Streuung von jedem Startort zu jedem Zielort abgeschlossen, werden die Markierungen respektive Aufenthaltsanteile 5 auf den Kanten summiert. Diese Summen sind ein Mass für die Verkehrsdichten und, daraus abgeleitet, auch die Verkehrsflüsse der einzelnen Wegabschnitte 3 im Verkehrsnetz 10. Aus der Verkehrsdichte kann eine Geschwindigkeit der Verkehrsteilnehmer in den Wegabschnitten 3 berechnet werden. Dazu bestehen bekannte Verfahren. Sie gehen davon aus, dass Verkehrsteilnehmer mit einer sicheren Fahrweise ihre Geschwindigkeit der Dichte anpassen, unter Einhalten der örtlichen Maximalgeschwindigkeit. Aus der Verkehrsdichte und der Geschwindigkeit wiederum kann der Verkehrsfluss bestimmt werden.

Allgemein gilt, dass der Verkehrsfluss (Anzahl Fahrzeuge je Zeiteinheit) gleich dem Produkt von Geschwindigkeit (Strecke je Zeiteinheit) und Verkehrsdichte (Anzahl Fahrzeuge je Strecke) ist.

**Figur 3** zeigt beispielhaft den Verkehrszustand, d.h. die sich ergebenden Belastungen der Wegabschnitte, nachdem die Verkehrsteilnehmer respektive ihre Aufenthaltsanteile 5 für alle Startorte und Zielorte gestreut worden sind.

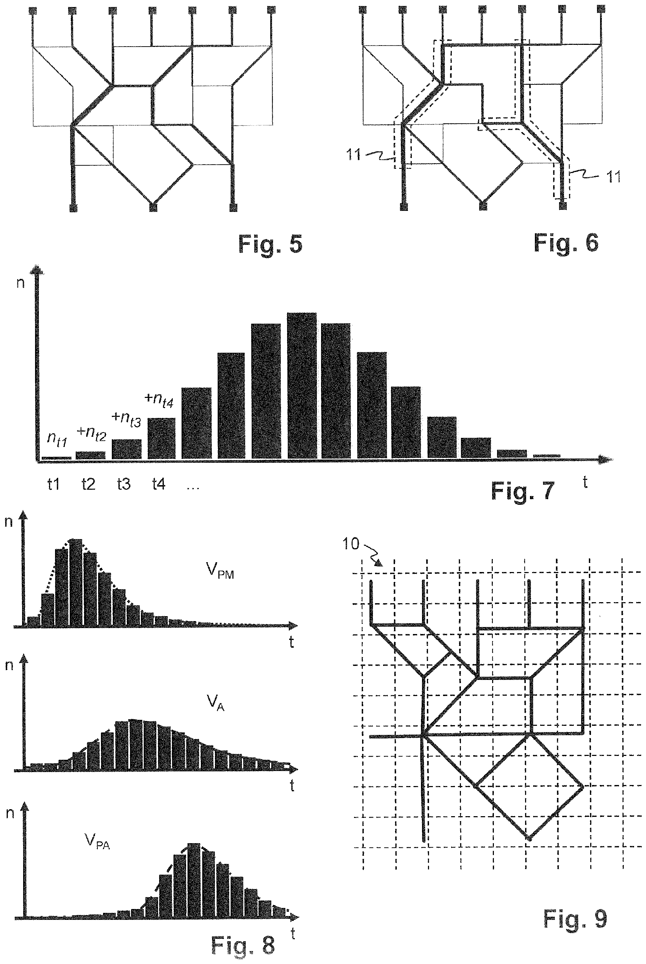

In **Figur 4** werden die Markierungen der Streuungen durch Strichstärken ersetzt, welche die Verkehrsdichten oder Verkehrsflüsse aus dem generierten Verkehr zeigen. **Figur 5** zeigt nur noch die Strichstärken, welche aus den Verkehrsdichten oder Verkehrsflüssen des erzeugten Verkehrs resultieren. In diesen Beispielen sind die Strichstärken vereinfacht und nicht gemäss der Bewegungsrichtung dargestellt. In anderen Ausführungsformen werden bei jeder Kante zwei Striche angezeigt, jeweils mit einer Stärke oder anderen grafischen Markierung entsprechend der Abschnittsdichte 9 in jeder den beiden Fahrtrichtungen respektive Wegabschnitten 3 entlang der Kante.

Die bisherige beispielhafte Beschreibung gilt für Verkehrsnetze mit gleichen Streckenabschnitten, oder Strecken gleicher Länge.

Für Verkehrsnetze mit unterschiedlichen Streckenabschnitten, beziehungsweise unterschiedlicher Kantenlängen, können die Markierungen proportional zu den Streckenabschnitten, beziehungsweise den Kantenlängen, vorgenommen werden. Das bedeutet, dass die Streuung auf einen einzelnen Streckenabschnitt proportional zur Weglänge von einem Startort zum Zielort erfolgt: je länger ein Streckenabschnitt ist, desto mehr Anteile eines Verkehrsteilnehmers erhält er, relativ zu den anderen Streckenabschnitten.

Sind im Verkehrssystem Zielorte eingebunden, welche eine unterschiedliche Attraktivität aufweisen, zum Beispiel beim Einkaufsverkehr unterschiedliche Einkaufsmöglichkeiten, so können die Teilung und die Streuung der einzelnen Verkehrsteilnehmer zur Anzahl der möglichen Zielorte eine Gewichtung erhalten, insbesondere eine relative Gewichtung, entsprechend der Attraktivität der Zielorte. Diese Gewichtung kann Zielgewichtungsfaktor genannt werden. Mehrere Zielgewichtungsfaktoren können jeweils als reelle, insbesondere ganzzahlige Werte den Zielorten zugeordnet sein. Sie können auch skaliert oder normiert sein, beispielsweise durch Division durch die Summe aller Zielgewichtungsfaktoren des betrachteten Netzes.

Ändern sich im Ablauf des Verfahrens die Abschnittsdichten 9, kann dies bei der Bestimmung der optimalen Wege berücksichtigt werden. Auch kann berücksichtigt werden, wenn die Abschnittsdichte 9 in einem Wegabschnitt 3 bezüglich einer Abschnittskapazität 8 dieses Wegabschnitts 3 zu gross wird. Somit können sich entsprechend dem Zustand des Verkehrsnetzes andere optimale Wege 6 von einem Startort zu den Zielorten ergeben. Dann erfolgt die weitere Streuung auf den neuen optimalen Wegen 6. Um die Simulation unabhängig von der Reihenfolge zu machen, in welche die Startorte 1 abgearbeitet werden, kann die iterative Streuuung der Verkehrsteilnehmer der Startorte 1 die Reihe der Startorte 1 mehrmals durchlaufen, wobei bei jedem Durchlauf nur ein Teil der Verkehrsteilnehmer jedes Standortes gestreut wird.

### Abbildung von zeitlichen Verkehrsschwankungen

Die zeitlichen Schwankungen der Verkehrsbelastungen können ebenfalls abgebildet werden. Entsprechend dem Aufkommen des Verkehrs und wieder Abfallen des Verkehrs wird die Streuung proportional zum Verkehrsaufkommen verstärkt oder geschwächt. Das bedeutet, die Verkehrsteilnehmer aus einem Startort werden nicht alle gleichzeitig zur Streuung verwendet. Entsprechend einer zeitlichen Verteilung des Verkehrsaufkommens (**Figur 7**) wird die Anzahl der Verkehrsteilnehmer eines Startortes über die Zeit aufgeteilt. Proportional zur Verteilung des Verkehrsaufkommens werden die einzelnen Teile der Verkehrsteilnehmer eines Startortes ebenfalls zeitlich verteilt und zur Streuung verwendet. Es werden jeweils Zeitabschnitte einer bestimmten Länge betrachtet, beispielsweise eine Minute, fünf, zehn, fünfzehn, dreissig oder sechzig etc. Minuten. In jedem Zeitabschnitt der Simulation wird bei den Startorten eine Anzahl zugeordneter Verkehrsteilnehmer entsprechend der Höhendifferenzen des jeweiligen Balkens in **Figur 7** in Verkehrsteilnehmerbruchteile aufgeteilt eingestreut: zu einem Zeitpunkt t1 respektive einem darum liegenden Zeitabschnitt wird eine Anzahl *nₜ₁* Verkehrsteilnehmer auf Verkehrsteilnehmerbruchteile aufgeteilt eingestreut. Zu einem Zeitpunkt t2 werden zusätzliche *nₜ₂* Verkehrsteilnehmer eingestreut, wodurch sich das gesamte Verkehrsaufkommen um *nₜ₂* erhöht, dargestellt durch die Höhe des Balkens bei t2. Zu weiteren Zeitpunkten t3, t4, etc. erhöht sich das Verkehrsaufkommen weiter. Dadurch ändern sich im Ablauf des Verfahrens nach jedem Zeitabschnitt die Abschnittsdichten 9, was wie schon oben erwähnt bei der Bestimmung der optimalen Wege berücksichtigt werden kann. Nach einer gewissen Verweilzeit werden Verkehrsteilnehmer respektive ihre Verkehrsteilnehmerbruchteile wieder aus dem Verkehrsnetz entfernt, und das Verkehrsaufkommen sinkt. Diese Verweilzeit kann je nach Detaillierungsgrad des Modells beispielsweise für alle Verkehrsteilnehmerbruchteile gleich sein, oder sie kann für verschiedene Verkehrsteilnehmerbruchteile unterschiedlich sein, beispielsweise entsprechend einer Weglänge, über die ein Verkehrsteilnehmerbruchteil aufgeteilt wird.

In jedem Fall ergibt sich das Verkehrsaufkommen als Integral der Änderungen durch eingestreute respektive entfernte Verkehrsteilnehmerbruchteile. Es ist in den nachfolgenden Schritten mathematisch gleichwertig, ob das Verkehrsaufkommen oder dessen Änderungen bestimmt werden.

Bei dieser zeitlichen Verteilung und Streuung kann also jeder Verkehrsteilnehmer, respektive können seine Aufenthaltsanteile, über eine bestimmte Dauer einer Simulationszeit hinweg, in den Wegabschnitten vorliegen. Während dieser Dauer der (Simulations)Zeit tragen sie zur Summation der Aufenthaltsanteile bei, anschliessend wieder nicht. Sie können während dieser Dauer auch nur mit einer zeitlich variierenden Gewichtung beitragen.

Bezogen auf die Darstellung gemäss der **Figur** 3 bedeutet dies, dass beim Durchlaufen der Simulationszeit die einzelnen Aufenthaltsanteile 5 erscheinen und wieder verschwinden.

Dabei kann auch die zeitliche Verteilung der Verkehrsteilnehmer über die jeweiligen optimalen Wege 6 und die Wegabschnitte 3 ermittelt werden, ausgehend von der erwähnten zeitlichen Verteilung von Startzeiten. Die Geschwindigkeit und der Verkehrsfluss in einem Wegabschnitt 3 wiederum können von der Abschnittsdichte 9 im Wegabschnitt 3 abhängen respektive durch bekannte Verfahren aus diesen ermittelt werden. Wie oben schon erwähnt, können sich bei zunehmenden Abschnittsdichten 9 in Bezug zu den Abschnittskapazitäten 8 die optimalen Wege 6 ändern.

Zusammenfassend kann also aus einer Startzeitverteilung, welche zu jedem Zeitabschnitt angibt, wieviele Verkehrsteilnehmer in das Verkehrsnetz eingebracht werden, das Verkehrsaufkommen als zeitliche Streuuung der Verkehrsteilnehmer bestimmt werden, wie in der **Figur 7** dargestellt. Eine Startzeitverteilung kann optional auch eine Verweilzeit je Verkehrsteilnehmer definieren, oder jeweils zu bestimmten Zeitabschnitten, wieviele Verkehrsteilnehmer aus dem Verkehrsnetz entfernt werden. Die Verweilzeit je Verkehrsteilnehmer kann beispielsweise für alle Verkehrsteilnehmer gleich sein, oder sie kann für alle Verkehrsteilnehmer einer bestimmten Verkehrsart gleich sein, oder sie kann für einzelne Verkehrsteilnehmerbruchteile gemäss einer Länge des optimalen Weges zu ihrem Zielort bestimmt werden.

Die genannte zeitliche Streuung der Verkehrsteilnehmer kann an eine gemessene zeitliche Verteilung des Verkehrsaufkommens angepasst werden. Beispielsweise wird von Verteilung der Startzeiten in den Startorten ausgegangen, welche zu einer Gaussverteilung oder einer Dreiecksverteilung des Verkehrsaufkommens führt.. Es können bei allen Startorten die gleiche oder verschiedene zeitliche Verteilungen gewählt werden. In einem Optimierungsverfahren können Parameter dieser Verteilungen (beispielsweise Breite und Höhe der Verteilung) variiert werden, um die zeitliche Verteilung der Belastung in Wegabschnitten, zu denen Messungen aus der Realität vorliegen, möglichst gut an diese anzugleichen. Wenn die Messungen einen Verkehrsfluss (also Fahrzeuge je Zeiteinheit) darstellen, kann zum Angleich aus der Belastung ebenfalls der (simulierte) Verkehrsfluss berechnet werden, wie andernorts schon beschrieben.

Die zeitliche Streuung der Verkehrsteilnehmer kann verschiedene Verkehrsarten repräsentieren, respektive diesen zugeordnet sein. **Figur 8** zeigt dem entsprechend das Verkehrsaufkommen verschiedener Verkehrsarten, entlang einer Zeitachse t verteilt über die Dauer eines Tages. Beispielhaft zeigt die oberste Grafik das Verkehrsaufkommen für morgendlichen Pendlerverkehr, die mittlere für Arbeitsverkehr und die untere für abendlichen Pendlerverkehr. Die gesamte Anzahl der Verkehrsteilnehmer einer Verkehrsart ist gleich der Summe der über die einzelnen Zeitabschnitte der gesamten Zeitdauer verteilten Verkehrsteilnehmer.

Die gesamte Anzahl der Verkehrsteilnehmer pro Verkehrsart und die Startorte 1 und Zielorte 2 im Verkehrsnetz 10 können beispielsweise aus urbanen Statistiken in folgender Weise erzeugt werden, wie schon bezüglich der **Figur 1** erläutert. **Figur 9** zeigt ein Verkehrsnetz 10 mit darüber gelegtem Raster. Aus urbanen Statistiken ist zu jedem Feld im Raster beispielsweise zu Wohnbevölkerung, Arbeitsplätzen, Einkaufsmöglichkeiten, Freizeitangeboten, etc. eine entsprechende Anzahl von Personen oder eine Nutzungskapazität bekannt. Je nach Verkehrsart ergeben sich daraus unterschiedliche Startorte und Zielorte sowie diesen zugeordnete Mengen. Beispielsweise sind für den morgendlichen Pendlerverkehr die Startorte und eine jeweilige Gesamtzahl von Verkehrsteilnehmern pro Startort durch die Wohnbevölkerung in den verschiedenen Rasterfeldern bestimmt, und die Zielorte und eine proportionale Aufteilung der Verkehrsteilnehmer durch die Anzahl von Arbeitsplätzen in den verschiedenen Rasterfeldern. Analog werden die Anzahl von Teilnehmern an anderen Verkehrsarten sowie deren Startorte und Zielorte entsprechend der Verteilung auf die Rasterfelder wie folgt bestimmt:

| | |
|---|---|
| • Pendlerverkehr morgens: | Wohnorte - Arbeitsplätze |
| • Pendlerverkehr abends: | Arbeitsplätze - Wohnorte |
| • Shoppingverkehr: | Wohnorte - Verkaufsnutzungen |
| • Shoppingverkehr Rückreise: | Verkaufsnutzungen - Wohnorte |
| • Arbeitsverkehr: | Arbeitsorte untereinander |
| • etc.: weitere Zuordndungen gemäss urbanen Statistiken Beispielsweise ist beim Pendlerverkehr die absolute Anzahl Verkehrsteilnehmer durch die Anzahl erwärbstätiger Bewohner an den Wohnorten vorgeben, und geschieht die Aufteilung dieser Anzahl entsprechend den Arbeitsplätzen in den verschiedenen Rasterfeldern. | |

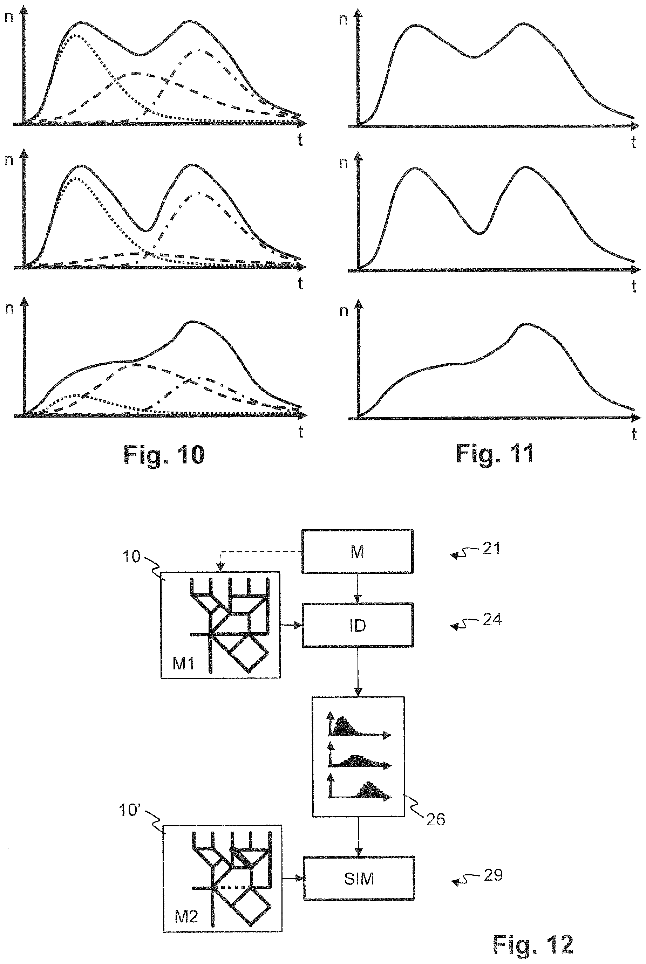

Die Simulation durch Streuung der Verkehrsteilnehmer der verschiedenen Verkehrsarten über das Verkehrsnetz 10 geschieht wie oben erläutert. Daraus lässt sich in der Simulation des Verkehrsnetzes 10 für jeden Streckenabschnitt und jeden betrachteten Zeitabschnitt bestimmen, welches der Anteil der verschiedenen Verkehrsarten am Gesamtverkehr ist. **Figur 10** zeigt eine Überlagerung von verschiedenen Verkehrsarten an drei verschiedenen Stellen im Verkehrsnetz. Die drei unterbrochenen Kurvenverläufe entsprechend Pendlerverkehr morgens, Arbeitsverkehr und Pendlerverkehr abends. Die ausgezogene Kurve entspricht deren Summe. In der mittleren Grafik hat der Arbeitsverkehr, verglichen mit der obersten, einen kleineren Anteil an der Gesamtbelastung. In der unteren Grafik hat der morgendliche Pendlerverkehr einen kleineren Anteil.

**Figur 11** zeigt Tagesgangskurven an Zählstellen im Verkehrsnetz. Diese geben den an den Zählstellen jeweils erfassten Verkehrsfluss (Anzahl von n Fahrzeugen pro Zeiteinheit, beispielsweise pro Minute) über eine bestimmte Zeitdauer wieder, in diesem Fall über einen Tag. In einem realen Verkehrsnetz sind je nach Grösse Dutzende bis hunderte von Zählstellen vorhanden. In der Regel werden die Fahrzeuge nach Fahrtrichtung getrennt erfasst.

Stammt eine Tagesgangskurve aus einer Simulation, so sind die Beiträge der verschiedenen Verkehrsarten bekannt, wie in **Figur 10** gezeigt. Stammt eine Tagesgangskurve aus Messungen, so ist lediglich die Summe aller Verkehrsarten bekannt, wie in **Figur 11****.** In diesen Beispielen sind die Tagesgangskurven aus Messung und Simulation identisch, entsprechend einer perfekten Simulation. In der Realität ist dies in der Regel nicht der Fall.

Für die Qualität der Modellierung und damit auch der Simulation kann von Vorteil sein, Anteile einer Tagesgangskurve jeweils den verschiedenen Verkehrsarten zuordnen zu können. Da in der Realtät nur die Summen erfasst werden können, werden gemäss dem nachfolgend beschriebenen Vorgehen die Anteile der Verkehrsarten durch Angleichen des Modells an die Realität ermittelt, so dass dieses die gemessenen Tagesgangskurven nachbildet.

Um Parameter der Simulation der Realität anzugleichen, im regelungstechnischen Sprachgebrauch "Systemidentifikation" genannt, kann gemäss Ausführungsformen davon ausgegangen werden, dass die Topologie des realen Verkehrsnetzes korrekt im Modell abgebildet ist. Die Gesamtsumme pro Verkehrsart kann als konstant betrachtet werden, beispielsweise vorgegeben gemäss urbanen Statistiken. Als Freiheitsgrade, entsprechend zu identifizierenden Parametern, wird das Verkehrsaufkommen der verschiedener Verkehrsarten betrachtet. Dieses kann als zeitliche Verteilung des Verkehrsaufkommens selbst dargestellt werden, oder in Form der Änderung des Verkehrsaufkommens, ausgedrückt durch Startzeiten und Verweilzeiten von Verkehrsteilnehmern. Wie oben schon beschrieben, kann ein Optimierungsverfahren Parameter der zeitlichen Verteilung variieren, und zwar separat für die verschiedenen Verkehrsarten. Abhängig von der Komplexität des Verkehrsnetzes 10 und der Anzahl der Zählstellen kann eine mehr oder weniger komplexe Repräsentation der jeweiligen zeitlichen Verteilungen identifiziert werden. Eine solche Repräsentation kann beispielsweise sein
- Zentrum und Varianz einer Normalverteilung;
- Parameter einen anderen Verteilung; oder
- für jeden der Zeitabschnitte, die Anzahl der zugeordneten Verkehrsteilnehmer.

Dabei kann jeweils die Randbedingung gelten, dass die Summe über alle Zeitabschnitte vorgegeben ist.

Optimierungsalgorithmen, die zur Anwendung kommen können sind bekannt, beispielsweise stochastische Optimierung, genetische Algorithmen, etc.

**Figur 12** zeigt in einer Übersichtsdarstellung einen Ablauf zum Abgleichen eines Modells mit gemessenen Tagesgangskurven und zum Durchführen von prädiktiven Simulationen mit dem abgeglichenen Modell: in einem Abschnitt der Verkehrserfassung 21 werden im realen Verkehrssystem erfasste Tagesgangskurven erfasst. In einem Abschnitt der Identifikation 24 wird daraus das Verkehrsaufkommen 26 der verschiedenen Verkehrsarten bestimmt, oder, äquivalent dazu, entsprechende Startzeitverteilungen. Die Identifikation 24 verwendet dabei ein modelliertes Verkehrsnetz 10, dessen Topologie die Topologie des realen Verkehrssystems wiedergibt. Das Nachführen der Topologie des realen Verkehrssystems im modellierten Verkehrsnetz 10 ist durch einen strichlierten Pfeil dargestellt.

Es wird nun davon ausgegangen, dass das so ermittelte Verkehrsaufkommen, also die zeitliche Verteilung 26, für ein gleich geartetes Verkehrsszenario dasselbe ist. Somit können, zu einem späteren Zeitpunkt, nachdem Änderungen im realen Verkehrssystem 22 stattgefunden haben, z.B. durch Baustellen, diese Änderungen im Modell des Verkehrsnetzes 10' nachgeführt werden. Dieses Modell mit der angepassten Topologie kann zusammen mit dem ermittelten Verkehrsaufkommen 26 respektive mit den diesem zugrundeliegende Startzeitverteilungen für eine prädiktive Simulation 29 verwendet werden.

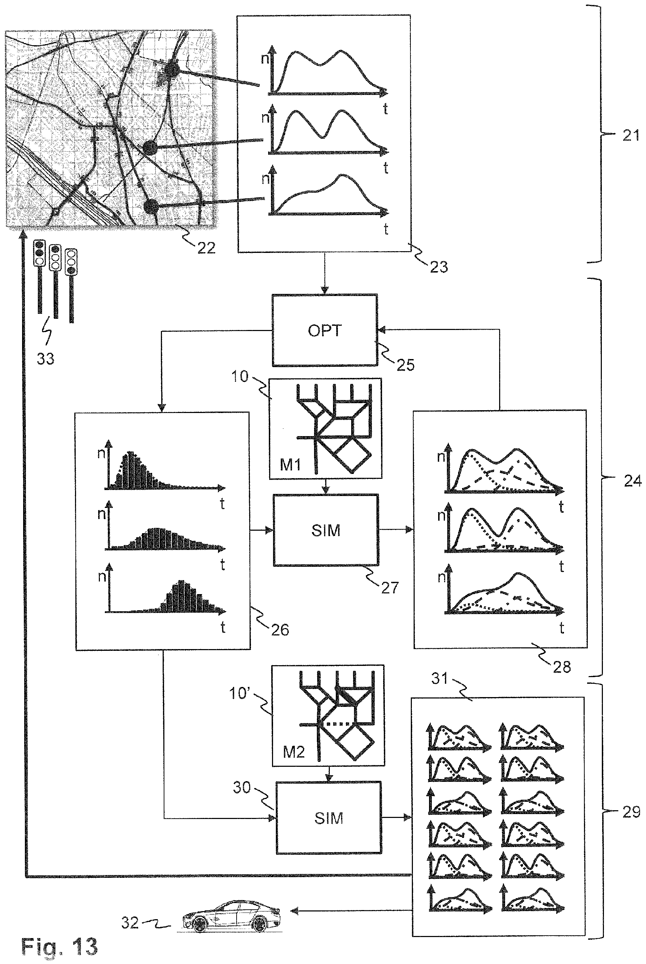

**Figur 13** zeigt den zugrunde liegenden Ablauf gemäss einer möglichen Ausführungsform, mit einem höheren Detaillierungsgrad: in einem Abschnitt der Verkehrserfassung 21 werden im realen Verkehrssystem 22 an verschiedenen Zählstellen Tagesgangskurven 23 erfasst. In einem Abschnitt der Identifikation 24 werden mit einem Optimierungsverfahren 25 die Startzeitverteilungen respektive das Verkehrsaufkommen 26 verschiedener Verkehrsarten variiert, um eine Simulation 27 anhand des modellierten Verkehrsnetzes 10, welche simulierte Tagesgangskurven 28 erzeugt, mit den erfassten Tagesgangskurven 23 abzugleichen.

Das Optimierungsverfahren 25 geht davon aus, dass beim Abgleich die Topologie des modellierten Verkehrsnetzes 10 und des realen Verkehrssystems 22 identisch sind. Nachdem das Optimierungsverfahren 25 abgeschlossen ist, liegen als Ergebnis die Startzeitverteilungen und/oder Verkehrsaufkommen 26 der verschiedenen Verkehrsarten vor. Wie schon beschrieben kann mit den derart ermittelten Startzeitverteilungen respektive Verkehrsaufkommen 26 mit einer anderen, insbesondere zukünftigen Topologie des modellierten Verkehrsnetzes 10' eine Simulation 30 durchgeführt werden. Dies entspricht dem Abschnitt der prädiktiven Simulation 29 in den **Figuren 12** und **13**.

In dieser prädiktiven Simulation sind die Anteile der verschiedenen Verkehrsarten, ausgedrückt durch prädiktive Tagesgangskurven 31, bekannt. Somit lässt sich eine angepasste Steuerung des realen Verkehrssystems 22 durch beispielsweise Verkehrsampeln 33 realisieren.

In Ausführungsformen werden anstelle der Optimierungsalgorithmen Verfahren zum maschinellen Lernen eingesetzt. Dazu werden in einem ersten Schritt, zum Generieren von Trainingsdaten,
- eine Topologie des Verkehrsnetzes 10 vorgegeben;
- mehrere Startzeitverteilungen und/oder Verkehrsaufkommen verschiedener Verkehrsarten vorgegeben, also mehrere für morgendlichen Pendlerverkehr (V_{PM1}, V_{PM2}, ...), mehrere für Arbeitsverkehr (V_{A1}, V_{A2}, ...), mehrere für abendlichen Pendlerverkehr (V_{PA1}, V_{PA2}, ...) etc.;
- Verschiedene Sätze mit Kombinationen der Startzeitverteilungen und/oder Verkehrsaufkommen der verschiedenen Verkehrsarten ({V_{PM1}, V_{A1}, V_{PA1} }; {V_{PM1}, V_{A2}, V_{PA1} }; {V_{PM1}, V_{A1}, V_{PA2} }; ...), und für jeden Satz und für die vorgegebene Topologie jeweils mittels der Verkehrsflusssimulation Tagesgangskurven an mehreren Zählstellen bestimmt, welche jeweils Zählstellen in realen Verkehrsnetz entsprechen.

In einem zweiten Schritt wird ein lernendes System mit den Sätzen von Startzeitverteilungen und/oder Verkehrsaufkommen und den zugeordneten Tagesgangskurven trainiert. Inputdaten sind dabei die Tagesgangskurven, Outputdaten, deren Zuordnung zu den Inputdaten das System lernen soll, sind die Sätze von Startzeitverteilungen und/oder von Verkehrsaufkommen der verschiedenen Verkehrsarten.

In einem dritten Schritt wird die gelernte Zuordnung genutzt: dazu wird das lernende System mit gemessenen Tagesgangskurven, die im realen System (dessen Topologie im ersten Schritt beim Lernen verwendet wurde) an den Zählstellen ermittelt wurden, als Inputdaten gespeist. Daraus ermittelt das lernende System die passenden Sätze von Startzeitverteilungen und/oder von Verkehrsaufkommen der verschiedenen Verkehrsarten.

Damit liegen, wie beim oben beschriebenen Optimerungsverfahren, als Ergebnis die Startzeitverteilungen und/oder Verkehrsaufkommen 26 der verschiedenen Verkehrsarten vor, und können in der prädiktiven Simulation 29 verwendet werden.

### Anwendung der Verkehrsflusssimulation

Ein typisches Strassennetz einer Stadt weist viele Strassenbaustellen auf, welche den Verkehrsfluss laufend verändern. Im Durchschnitt sind es z.B. in Europäischen Städten eine Baustelle auf 300 bis 500 Einwohner. Das kann für eine Stadt mit 100'000 Einwolmern 200 bis 350 Baustellen ergeben. In der Summe bleibt die Anzahl der Strassenbaustellen etwa gleich, aber ihre Standorte ändern sich laufend.

Die Strassenbaustellen einer Stadt verändern wöchentlich, oft auch täglich, das Verkehrsnetz. Diese Veränderungen des Verkehrsnetzes haben einen grossen Einfluss auf die Verkehrsflüsse. Wöchentlich, oder fast täglich suchen die Verkehrsteilnehmer ihren optimalen Weg durch das Strassennetz. Zudem erfährt eine Stadt ein Wachstum an Bewohnern und Arbeitsplätzen, was ebenfalls das Verkehrsnetz und die Verkehrsbelastung laufend ändert.

Bei herkömmlichen Verkehrssimulationen, in denen Statistiken der Verkehrszählungen verwendet werden, kann immer nur ein historisches Verkehrsverhalten analysiert werden. Die Ergebnisse hinken hinter der Realität her: Bis solche Analysen durchgeführt sind, hat sich das Verkehrsverhalten aufgrund des veränderten Strassennetzes bereits wieder verändert.

Mit dem hier beschriebenen Verfahren zur Verkehrssimulation oder Verkehrsanalyse kann der Verkehr für einen bestimmten Zustand des Verkehrsnetzes real abgebildet werden. Zudem wird der Verkehr nicht aus einer Verkehrsstatistik generiert, sondern aus der urbanen Statistik (Einwohner, Arbeitsplätze, Nutzungen etc.). Wird ein Strassennetz verändert, so kann bereits in der Planungsphase das Verkehrsverhalten (Verkehrsdichten, Verkehrsflüsse, Geschwindigkeiten etc.) einer gesamten Stadt prädiktiv analysiert werden. Diese prädiktiven Analysen bilden die Grundlagen um den Strassenverkehr, zum Zeitpunkt wenn die entsprechenden Strassenbaustellen eröffnet werden, optimal zu lenken.

Zur Erläuterung zeigen die **Figuren 5** und **6** ein Strassennetz **(****Figur 5**) und dasselbe Strassennetz abgeändert **(****Figur 6**). Wird ein Verkehrsnetz abgeändert, ergibt sich über das abgeänderte Verkehrsnetz eine andere Streuung der Verkehrsteilnehmer. Die Verkehrsdichten sowie Verkehrsflüsse oder Fahrgeschwindigkeiten können sehr schnell und effizient ermittelt werden.

Herkömmliche Verkehrssimulationen haben ein Problem zur Ermittlung der Aufteilung des Verkehrs an Strassenkreuzungen oder Strassengabelungen: es muss entschieden werden, welchen Weg ein einzelner Verkehrsteilnehmer wählt. Dies führt zu Ungenauigkeiten der Verkehrsdichten und Verkehrsflüsse. Durch das hier beschriebenen Verfahren zur Verkehrssimulation oder Verkehrsanalyse wird dieses Problem ganz einfach durch die Streuung gelöst: der Verkehrsteilnehmer wird - anteilsmässig - mehreren Wegen zugeordnet. Erstaunlicherweise ergibt sich daraus ein aussagekräftiges Modell des Gesamtverhaltens aller Verkehrsteilnehmer.

### Anwendung zur Verkehrssteuerung

Eine mögliche Anwendung ist die Koordinierung von Lichtschaltzeiten der Ampeln. In den meisten Städten sind die Lichtschaltzeiten der Ampeln für längere Zeiten auf eine fixe Zeit eingestellt. Verkehrsnetze der Städte werden aber wöchentlich oder täglich durch Strassenbaustellen verändert. Damit der Verkehr verflüssigt werden kann, können die Lichtschaltzeiten der Ampeln entsprechend dem erwarteten Verkehrsfluss angepasst werden.

Beispielsweise können Ampeln an einer Kreuzung so eingestellt werden, dass Verkehrsteilnehmer aus einem Wegabschnitt 3 bevorzugt werden, für den das Verfahren eine hohe Abschnittsdichte 9 - relativ zu anderen Wegabschnitten 3, die in die Kreuzung münden - ermittelt hat.

In Ausführungsformen werden belastete Routen bestimmt und bei der Schaltung der Ampeln bevorzugt. Belastete Routen bestehen aus Wegabschnitte mit relativ hoher Belastung ("belastete Wegabschnitte"). Eine belastete Route weist jeweils eine Folge von solchen Wegabschnitten auf. Sie bilden einen gerichteten Graphen ohne Schleifen. Dabei kann sich die Route verzweigen, indem ein belasteter Wegabschnitt sich in zwei anschliessende belastete Wegabschnitte aufteilt, oder zwei belastete Wegabschnitte sich zu einem vereinen. Es können mehrere disjunkte belastete Routen in einem Verkehrsenetz vorliegen. In einem einfachen Fall weiste eine belastete Route nur eine Sequenz von aufeinanderfolgenden belasteten Wegabschniten auf, ohne Verzweigungen. In der **Figur 6** sind beispielhaft zwei belastete Routen 11 strichliert umrandet: links eine ohne, rechts eine mit Verzweigungen.

Zur Bestimmung von belasteten Routen kann beispielsweise von einem ersten Wegabschnitt mit maximaler Belastung ausgegangen werden. Dann kann von diesem aus - in Bewegungsrichtung - vorwärts und rückwärts nach angrenzenden Wegabschnitten (jeweils einer oder mehr) mit hoher Belastung gesucht werden, welche den ersten Wegabschnitt speisen oder von diesem gespeist werden. Dieser Schritt kann iterativ vorwärts und rückwärts wiederholt werden, bis die Belastungen der betrachteten Wegabschnitte unter ein bestimmtes Mass fallen.

Eine belastete Route kann durch die Schaltung der Ampeln bevorzugt werden, indem wiederholt während einer bestimmten Zeitdauer - beispielsweise eine, zwei, drei oder mehr Minuten - alle Ampeln in der betrachteten Bewegungsrichtung entlang der belasteten Route auf grün geschaltet werden. Bei grösseren Verkehrsnetzen und grösseren Abständen zwischen Ampeln kann generell auch die Zeitdauer grösser gewählt werden.

Da die Verkehrsnetze respektive deren Topologie sich auch wöchentlich oder täglich ändern, z.B. durch Strassenbaustellen, ändert sich entsprechend auch der Verkehrsfluss auf eine Kreuzung. Während den Stosszeiten kann sich der Verkehrsfluss an einer Kreuzung innerhalb von Minuten ändern. Um den Verkehr verflüssigen zu können, müssen alle Ampeln eines Verkehrsnetzes die Lichtschaltzeiten innerhalb weniger Minuten entsprechend dem Verkehrsfluss ändern. Zudem müssen alle Ampeln eines Verkehrsnetzes durch diese Dynamik genau aufeinander abgestimmt sein. Eine solche Anpassung und Abstimmung kann mit dem hier vorgestellten Verfahren zur Verkehrsflusssimulation mit besserer Qualität realisiert werden als mit herkömmlichen Systemen, da ersteres eine prädiktive und der aktuellen Netztopolgie angepassten, Simulation und Ermittlung der Belastungen realisiert. Letztere hingegen verfügen nur über
- historische Messdaten über einen ganzen Tagesverlauf, die aber auf einer nicht mehr aktuellen Netztopologie beruhen, oder über
- Echtzeit-Daten über den Verkehrsfluss, die aber keine Aussage über die Zukunft enthalten.

Durch das hier beschriebene Verfahren zur Verkehrsflusssimulation und Verkehrsanalyse kann das Verkehrsnetz, mit aktuellen und zukünftigen Verkehrsveränderungen, prädiktiv über frei wählbare Zeitintervalle im Voraus analysiert werden. Damit können die Lichtschaltzeiten von Ampeln bestimmt und zueinander koordiniert werden, oder andere Verkehrsleitsysteme angesteuert und zueinander koordiniert werden. Dadurch kann proaktiv und im Voraus auf das erwartete Verkehrsverhalten in verschiedenen und wechselnden Zuständen des Verkehrsnetzes und seiner Belastung reagiert und der Verkehr zur Verflüssigung möglichst optimal gelenkt werden.

## Patentansprüche

1. Computerimplementiertes Verfahren zur Verkehrsflusssimulation zur Bestimmung einer Belastung von Wegabschnitten (3) in einem Verkehrsnetz (10), ausgeführt auf einer digitalen Datenverarbeitungseinheit, ausgehend von
• einem Verkehrsnetz (10) als Graph aus Wegabschnitten (3) und Knoten (4),
• wobei eine erste Menge von Knoten (4) Startorte (1) sind, und jedem Startort (1) eine Startortanzahl von Verkehrsteilnehmern zugeordnet ist, und eine zweite Menge von Knoten (4) Zielorte (2) sind;
wobei nicht vorgegeben ist, zu welchem Zielort ein bestimmter Verkehrsteilnehmer von seinem Startort fährt, und zur Bestimmung der Belastung von Wegabschnitten (3) eine Streuung angewendet wird, bei welcher jeder einzelne Verkehrsteilnehmer von einem Startort auf die möglichen Zielorte aufgeteilt wird und ein entsprechender Verkehrsteilnehmerbruchteil, der einem bestimmten Zielort zugeordnet ist, jeweils gleich einem diesem Zielort zugeordneten Zielgewichtungsfaktor, dividiert durch die Anzahl der Zielorte, ist, und der Verkehrsteilnehmerbruchteil über die optimalen Wege zu allen möglichen Zielorten gestreut wird, indem die folgenden Schritte durchgeführt werden:
• für jeden Startort (1) und für jeden einzelnen der Verkehrsteilnehmer des Startorts (1):
o Bestimmen, zu jedem der Zielorte (2), jeweils eines zugeordneten Verkehrsteilnehmerbruchteiles des einzelnen der Verkehrsteilnehmer, entsprechend einer Aufteilung des einzelnen Verkehrsteilnehmers auf die Zielorte;
o Bestimmen, zu jedem der Zielorte (2), jeweils eines zugeordneten optimalen Wegs (6) vom Startort (1) zum Zielort (2);
o Bestimmen, zu jedem der Zielorte (2), und für jeden Wegabschnitt (3) des optimalen Wegs (6), eines Aufenthaltsanteils (5) des einzelnen Verkehrsteilnehmers im Wegabschnitt (3) als Funktion des Verkehrsteilnehmerbruchteiles, der diesem Zielort (2) zugeordnet ist;
• für jeden der Wegabschnitte (3) des Verkehrsnetzes (10):
o Bestimmen der Belastung des Wegabschnitts (3) durch Summation der Aufenthaltsanteile (5) aller Verkehrsteilnehmer in diesem Wegabschnitt (3).

2. Verfahren gemäss einem Anspruch 1, wobei der Aufenthaltsanteil (5) des Verkehrsteilnehmers im Wegabschnitt (3) als Funktion des Verkehrsteilnehmerbruchteiles bestimmt wird, indem der Aufenthaltsanteil (5) als Funktion des Verkehrsteilnehmerbruchteils und einer Abschnittslänge (7) des Wegabschnitts (3) bestimmt wird.

3. Verfahren gemäss Anspruch 2, wobei der Aufenthaltsanteil (5) des Verkehrsteilnehmers im Wegabschnitt (3) als Produkt des Verkehrsteilnehmerbruchteils und der Abschnittslänge (7), dividiert durch die Länge des zugeordneten optimalen Wegs (6), bestimmt wird.

4. Verfahren gemäss einem der vorangehenden Ansprüche, wobei
• bei der Iteration für jeden Startort (1) und für jeden der Verkehrsteilnehmer des Startorts (1) jeweils eine Startzeit vorgebbar ist;
• daraus jeweils eine Zeitinformation bestimmt wird, welche jedem der Aufenthaltsanteile (5) des Verkehrsteilnehmers in den Wegabschnitten (3) zugeordnet ist; und
• die Summation der Aufenthaltsanteile (5) aller Verkehrsteilnehmer in einem Wegabschnitt (3) unter Berücksichtigung der jeweiligen Zeitinformationen geschieht.

5. Verfahren gemäss Anspruch 4, wobei die Zeitinformation für alle Aufenthaltsanteile (5) eines Verkehrsteilnehmers dieselbe ist, und
insbesondere ein zeitlicher Verlauf einer Variation eines Beitrags der Aufenthaltsanteile (5) eines Verkehrsteilnehmers bei der Summation der Aufenthaltsanteile (5) in den Wegabschnitten (3) derselbe ist.

6. Verfahren gemäss einem der Ansprüche 4 oder 5, aufweisend die folgenden Schritte zur Bestimmung von Startzeiten der Verkehrsteilnehmer:
• Messen von zeitlichen Verläufen von realen Verkehrsflüssen, wobei jeder reale Verkehrsfluss einem realen Messungs-Wegabschnitt zugeordnet ist und in diesem gemessen wird;
• Durchführen eines Optimierungsverfahrens mit iterativ wiederholter Durchführung der Bestimmung der Belastung von Wegabschnitten (3), wobei die Startzeiten der Verkehrsteilnehmer variiert werden, um zeitliche Verläufe der Belastung von Wegabschnitten (3), welche den realen Messungs-Wegabschnitten entsprechen, den zeitlichen Verläufen der realen Verkehrsflüsse möglichst gut anzunähern.

7. Verfahren gemäss einem der vorangehenden Ansprüche, wobei mindestens zwei Verkehrsarten (*V1*, *V2,* ...) definiert sind, jede Verkehrsart (*V1*, *V2,* ...) eine zugeordnete Menge von Startorten (*M_{Start}(V)*) aufweist und eine zugeordnete Menge von Zielorten (*M_{Start}(V), M_{Ziel}(V)*) aufweist, und jeder Verkehrsteilnehmer einer Verkehrsart zugeordnet ist,
aufweisend die folgenden Schritte:
• Messen von zeitlichen Verläufen (23) von realen Verkehrsflüssen, wobei jeder reale Verkehrsfluss einem realen Messungs-Wegabschnitt in einem realen Verkehrssystem (22) zugeordnet ist und in diesem gemessen wird;
• Bestimmung von identifizierten Startzeitverteilungen und/oder Verkehrsaufkommen (26) der verschiedenen Verkehrsarten anhand der gemessenen zeitlichen Verläufe (23) und eines Modells des Verkehrsnetzes (10) mit der gleichen Topologie wie das reale Verkehrssystem (22);
• Bilden eines geänderten Modells des Verkehrsnetzes (10') durch Anpassen der Topologie nach Massgabe von Änderungen im realen Verkehrssystem (22);
• Bestimmung der Belastung von Wegabschnitten im geänderten Modell des Verkehrsnetzes (10`) unter Verwendung der identifizierten Startzeitverteilungen und/oder Verkehrsaufkommen (26) der verschiedenen Verkehrsarten.

8. Verfahren gemäss Anspruch 7, aufweisend die folgenden Schritte zur Bestimmung von identifizierten Startzeitverteilungen und/oder Verkehrsaufkommen (26) der verschiedenen Verkehrsarten:
• Durchführen eines Optimierungsverfahrens (25) mit iterativ wiederholter Durchführung der Bestimmung der Belastung von Wegabschnitten (3) im Modell des Verkehrsnetzes (10), wobei die Startzeitverteilungen und/oder die Verkehrsaufkommen (26) aller Verkehrsarten (*V1*, *V2,* ...) variiert werden, um zeitliche Verläufe der Belastung von Wegabschnitten (3), welche den realen Messungs-Wegabschnitten entsprechen, den gemessenen zeitlichen Verläufen (23) optimal anzunähern;
• Bestimmung der identifizierten Startzeitverteilungen und/oder Verkehrsaufkommen (26) als jene, welche zu dieser optimalen Annäherung führen.

9. Verfahren gemäss Anspruch 7, aufweisend die folgenden Schritte zur Bestimmung von identifizierten Startzeitverteilungen und/oder Verkehrsaufkommen (26) der verschiedenen Verkehrsarten:
• Trainieren eines Systems zum maschinellen Lernen mit mehreren Sätzen mit Kombinationen von Startzeitverteilungen und/oder Verkehrsaufkommen (26) der verschiedenen Verkehrsarten, wobei jedem dieser Sätze ein Satz von zeitlichen Verläufen der Belastung von Wegabschnitten (3) im Modell des Verkehrsnetzes (10) zugeordnet ist, wobei diese Wegabschnitte (3) den realen Messungs-Wegabschnitten entsprechen;
• Bestimmung der identifizierten Startzeitverteilungen und/oder Verkehrsaufkommen (26) durch das trainierte System zum maschinellen Lernen aus den gemessenen zeitlichen Verläufen (23).

10. Verfahren gemäss einem der vorangehenden Ansprüche, aufweisend mindestens einen der Schritte:
• Steuerung von Verkehrsleitmitteln, insbesondere Verkehrsampeln, nach Massgabe der Belastungen der Wegabschnitte (3);
• Steuerung von Navigationsgeräten in Fahrzeugen, nach Massgabe der Belastungen der Wegabschnitte (3).

11. Verfahren gemäss Anspruch 10, aufweisend die Schritte:
• Bestimmen mindestens einer belasteten Route als zusammenhängende Menge von in einer Bewegungsrichtung aufeinanderfolgenden Wegabschnitten (3), deren Belastung ein bestimmtes Mass überschreitet;
und mindestens einen der Schritte
• Schalten, während einer vorgegebenen Grünintervallzeit, aller Ampeln in der belasteten Route auf Grün;
• Eingriff in die Steuerung von Fahrzeugen in belasteten Routen.

12. Verfahren gemäss Anspruch 11, weiter abhängig von einem der Ansprüche 7 bis 9, wobei beim Bestimmen der mindestens einen belasteten Route (11) nur die Belastung durch eine Untermenge der verschiedenen Verkehrsarten berücksichtigt wird, insbesondere nur die Belastung durch eine einzige der Verkehrsarten.

13. Verfahren gemäss einem der Ansprüche 8 bis 12, aufweisend die Schritte:
• Eingabe eines Startortes und eines Zielortes eines realen Verkehrsteilnehmers;
• Bestimmen einer für diesen realen Verkehrsteilnehmer optimalen Route, unter Berücksichtigung von in der Zukunft liegenden Belastungen der Wegabschnitte (3) des Verkehrsnetzes;
• Übermittlung von Navigationsanweisungen entsprechend dieser optimalen Route an diesen realen Verkehrsteilnehmer.

14. Datenverarbeitungssystem zur Verkehrsflussimulation, wobei das Datenverarbeitungssystem Mittel aufweist zur Durchführung des Verfahrens nach einem oder mehreren der Ansprüche 1 bis 13.

15. Computerprogramm zur Verkehrsflussimulation, welches auf einer Datenverarbeitungseinheit ladbar und ausführbar ist, und welches bei der Ausführung das Verfahren nach einem oder mehreren der Ansprüche 1 bis 13 ausführt.

## Claims

1. A computer implemented method for traffic flow simulation so as to determine a traffic volume on route sections (3) in a traffic network (10), said method being performed on a digital data processing unit on the basis of:
• a traffic network (10) as a graph of route sections (3) and nodes (4),
• wherein a first set of nodes (4) are starting places (1) and each starting place (1) is allocated a starting place number of traffic participants, and a second set of nodes (4) are destinations (2);
wherein it is not predetermined which destination a specific traffic participant travels to from his starting place, and in order to determine a traffic volume of route sections (3) a dispersion is applied in which each separate traffic participant is dispersed from a starting place to the possible destinations, and a corresponding traffic participant fraction that is allocated to a specific destination respectively is equal to a destination weighting factor that is allocated to this destination divided by the number of destinations, and the traffic participant fraction is dispersed over the optimal paths to all possible destinations by performing the following steps:
• for each starting place (1) and for each of the traffic participants of the starting place (1):
o determining allocated to each of the destinations (2) respectively a traffic participant fraction, corresponding to an allocation of the traffic participants to the destinations;
o determining allocated to each of the destinations (2) respectively an optimal route (6) from the starting place (1) to the destination (2);
o determining for each of the destinations (2) and for each route section (3) of the optimal route (6) a dwell portion (5) of the traffic participant in the route section (3) as a function of the traffic participant fraction that is allocated to this destination (2);
• for each of the route sections (3) of the traffic network (10):
o determining the traffic volume on the route section (3) by means of summating the dwell portions (5) of all traffic participants in this route section (3).

2. The method as claimed in claim 1, wherein the dwell portion (5) of the traffic participant in the route section (3) is determined as a function of the traffic participant fraction in that the dwell portion (5) is determined as a function of the traffic participant fraction and a section length (7) of the route section (3).

3. The method as claimed in claim 2, wherein the dwell portion (5) of the traffic participant in the route section (3) is determined as a product of the traffic participant fraction and the section length (7) divided by the length of the allocated optimum route (6).

4. The method as claimed in one of the preceding claims, wherein
• a start time can be predetermined during the iteration for each starting place (1) and for each of the traffic participants of the starting place (1) respectively;
• from which in each case a time information is specified which is allocated to each of the dwell portions (5) of the traffic participants in the route sections (3); and
• the summation of the dwell portions (5) of all traffic participants in one route section (3) is performed by taking into consideration the respective time information.

5. The method as claimed in claim 4, wherein the time information for all the dwell portions (5) of a traffic participant is the same, and
in particular a temporal progression of a variation of a contribution of the dwell portions (5) of a traffic participant is the same for the summation of the dwell portions (5) in the route sections (3).

6. The method as claimed in claim 4 or 5, comprising the following steps so as to determine start times of the traffic participants:
• measure temporal progressions of real traffic flows, wherein each real traffic flow is allocated to a real measurement route section and is measured therein;
• perform an optimization method including the iteratively repeated procedure of determining the traffic volume on route sections (3), wherein the start times of the traffic participants are varied, in order for the temporal progressions of the traffic volume on route sections (3) that correspond to the real measurement route sections to be approximated in the best possible manner to the temporal progressions of the real traffic flows.

7. The method as claimed in one of the preceding claims, wherein at least two traffic types (*V1*, *V2,* ...) are defined, each traffic type (*V1*, *V2,* ...) comprises an allocated set of starting places (*M_{Start}(V)*) and an allocated set of destinations (*M_{Dest}(V)*) and each traffic participant is allocated to one traffic type, said method comprising the following further steps:
• measure temporal progressions (23) of real traffic flows, wherein each real traffic flow is allocated to a real measurement route section in a real traffic system (22) and is measured therein;
• determining identified start time distributions and/or traffic volumes (26) of the different traffic types on the basis of the measured temporal progressions (23) and a model of the traffic network (10) with the same topology as the real traffic system (22);
• form a modified model of the traffic network (10') by means of adjusting the topology according to changes in the real traffic system (22);
• determining the traffic volume on route sections in the modified model of the traffic network (10') by using the identified start time distributions and/or traffic volumes (26) of the different traffic types.

8. The method as claimed in claim 7, comprising the following steps so as to determine identified start time distributions and/or traffic volume (26) of the different traffic types:
• perform an optimization method (25) including the iteratively repeated procedure of determining the traffic volume on route sections (3) in the model of the traffic network (10), wherein the start time distributions and/or the traffic volumes (26) of all traffic types (*V1*, *V2,* ...) are varied, in order for the temporal progressions of the traffic volume on route sections (3) that correspond to the real measurement route sections to be approximated in an optimal manner to the measured temporal progressions (23);
• determining the identified start time distributions and/or traffic volume (26) as those which lead to this optimal approximation.

9. The method as claimed in claim 7, comprising the following steps so as to determine identified start time distributions and/or traffic volume (26) of the different traffic types:
• training a system for machine learning using multiple sets comprising combinations of start time distributions and/or traffic volumes (26) of the different traffic types, wherein each of these sets is allocated a set of temporal progressions of the traffic volume on route sections (3) in the model of the traffic network (10), wherein these route sections (3) correspond to the real measurement route sections;
• determining the identified start time distributions and/or traffic volumes (26) by means of the trained system for machine learning from the measured temporal progressions (23).

10. The method as claimed in one of the preceding claims, comprising at least one of the steps:
• controlling traffic guiding means, in particular traffic lights, according to the volumes of traffic on the route sections (3);
• controlling navigational devices in vehicles according to the volumes of traffic on the route sections (3).

11. The method as claimed in claim 10, comprising the steps:
• determining at least one busy route as an associated set of route sections (3) that follow one another in the direction of movement and whose traffic volume exceeds a specific amount;
and at least one of the steps:
• during a predetermined green interval time period, switch all the traffic lights in the busy route to green;
• engage in the control procedure of vehicles on busy routes.

12. The method as claimed in claim 11, further dependent upon one of claims 7 to 9, wherein when determining the at least one busy route (11) only the traffic volume produced by means of a subset of the different traffic types is taken into consideration, in particular only the traffic volume produced by means of one of the traffic types.

13. The method as claimed in one of claims 8 to 12, comprising the steps:
• input a starting place and a destination of a real traffic participant;
• determining an optimal route for this real traffic participant while taking into consideration future volumes of traffic of the route sections (3) of the traffic network;
• transmitting navigation instructions according to this optimal route to this real traffic participant.

14. A data processing system for traffic flow simulation, wherein the data processing system comprises means for performing the method according to one or more of claims 1 to 13.

15. A computer program for traffic flow simulation which can be loaded and executed on a data processing unit and which when executed performs the method as claimed in one or more of claims 1 to 13.

## Revendications

1. Procédé de simulation de flux de traffic mise en oeuvre par ordinateur pour déterminer une charge de tronçons de route (3) dans un réseau de trafic (10), exécuté sur une unité de traitement de données numériques, à partir de
- un réseau de circulation (10) sous la forme d'un graphe de tronçons de route (3) et de noeuds (4),
- dans lequel un premier ensemble de noeuds (4) sont des lieux de départ (1), et à chaque lieu de départ (1) est associé un nombre de lieux de départ d'usagers de la route, et un deuxième ensemble de noeuds (4) sont des lieux de destination (2);
dans lequel il n'est pas prédéterminé vers quelle destination un usager de la route particulier se dirige à partir de son point de départ, et pour déterminer la charge des sections de route (3), on applique une dispersion dans laquelle chaque usager de la route particulier est réparti d'un point de départ vers les destinations possibles et une fraction d'usager de la route correspondante associée à une destination particulière est respectivement égale à un facteur de pondération de destination associé à cette destination, divisé par le nombre de destinations, et la fraction d'usager de la route est dispersée sur les trajets optimaux vers toutes les destinations possibles en effectuant les étapes suivantes:
- pour chaque point de départ (1) et pour chacun des usagers de la route du point de départ (1):
• déterminer, vers chacune des destinations (2), une fraction d'usager de la route associée à chacun des usagers de la route, correspondant à une répartition de l'usager de la route individuel entre les destinations;
• déterminer, pour chacune des destinations (2), un trajet optimal respectif (6) du lieu de départ (1) au lieu de destination (2);
• déterminer, pour chacun des lieux de destination (2) et pour chaque section de trajet (3) du trajet optimal (6), une part de séjour (5) de l'usager de la route individuel dans la section de trajet (3) en fonction de la fraction d'usager de la route qui est associée à ce lieu de destination (2);
- pour chacun des tronçons de route (3) du réseau de transport (10):
• déterminer la charge du tronçon de route (3) par sommation des fractions de séjour (5) de tous les usagers de la route dans ce tronçon de route (3).

2. Procédé selon la revendication 1, dans lequel la part de séjour (5) de l'usager de la route dans le tronçon de route (3) est déterminée en fonction de la fraction d'usager de la route, en déterminant la part de séjour (5) en fonction de la fraction d'usager de la route et d'une longueur de tronçon (7) du tronçon de route (3).

3. Procédé selon la revendication 2, dans lequel la part de séjour (5) de l'usager de la route dans le tronçon de route (3) est déterminée en tant que produit de la part de fractionnement de l'usager de la route et de la longueur du tronçon (7), divisée par la longueur du chemin optimal (6) associé.

4. Procédé selon l'une quelconque des revendications précédentes, dans lequel
- lors de l'itération, une heure de départ peut être prédéfinie pour chaque lieu de départ (1) et pour chacun des usagers de la route du lieu de départ (1);
- on détermine à partir de là une information temporelle qui est associée à chacune des parties de séjour (5) de l'usager de la route dans les tronçons de route (3), et
- la sommation des parts de séjour (5) de tous les usagers de la route dans un tronçon de route (3) s'effectue en tenant compte des informations temporelles respectives.

5. Procédé selon la revendication 4, dans lequel l'information temporelle est la même pour toutes les parts de séjour (5) d'un participant au trafic, et
en particulier, l'évolution dans le temps d'une variation d'une contribution des parts de séjour (5) d'un participant au trafic est la même lors de la sommation des parts de séjour (5) dans les tronçons de route (3).

6. Procédé selon l'une des revendications 4 ou 5, comprenant les étapes suivantes pour déterminer les heures de départ des usagers de la route:
- Mesurer des évolutions temporelles de flux de trafic réels, chaque flux de trafic réel étant associé à une section de chemin de mesure réelle et mesuré dans celle-ci;
- Mise en oeuvre d'un procédé d'optimisation avec exécution itérative répétée de la détermination de la charge de tronçons de route (3), les temps de départ des usagers de la route étant modifiés afin de rapprocher le plus possible les évolutions temporelles de la charge de tronçons de route (3) qui correspondent aux tronçons de route de mesure réels des évolutions temporelles des flux de trafic réels.

7. Procédé selon l'une quelconque des revendications précédentes, dans lequel au moins deux types de trafic (V1, V2, ...) sont définis, chaque type de trafic (V1, V2, ...) ayant un ensemble associé de lieux de départ (Mstart(V)) et ayant un ensemble associé de lieux de destination (M_{Start}(V), M_{Destination}(V)), et chaque usager du trafic étant associé à un type de trafic,
comprenant les étapes suivantes:
- Mesurer des évolutions temporelles (23) de flux de trafic réels, chaque flux de trafic réel étant associé à une section de trajet de mesure réelle dans un système de trafic réel (22) et étant mesuré dans celui-ci;
- Déterminer des distributions de temps de départ et/ou des volumes de trafic (26) identifiés des différents types de trafic à partir des évolutions temporelles mesurées (23) et d'un modèle du réseau de transport (10) ayant la même topologie que le système de transport réel (22);
- former un modèle modifié du réseau de transport (10') en adaptant la topologie en fonction des modifications du système de transport réel (22);
- Déterminer la charge des tronçons de route dans le modèle modifié du réseau de transport (10') en utilisant les distributions de temps de départ et/ou les volumes de trafic (26) identifiés des différents types de trafic.

8. Procédé selon la revendication 7, comprenant les étapes suivantes pour déterminer les distributions de temps de départ et/ou les volumes de trafic (26) identifiés des différents types de trafic:
- Exécution d'un procédé d'optimisation (25) avec exécution répétée de manière itérative de la détermination de la charge de tronçons de route (3) dans le modèle du réseau de circulation (10), les distributions de temps de départ et/ou les volumes de circulation (26) de tous les types de circulation (V1, V2, ...) étant modifiés afin de rapprocher de manière optimale les évolutions temporelles de la charge de tronçons de route (3), qui correspondent aux tronçons de route réels mesurés, des évolutions temporelles mesurées (23);
- déterminer les distributions de temps de départ et/ou les volumes de trafic (26) identifiés comme étant ceux qui conduisent à cette approximation optimale.

9. Procédé selon la revendication 7, comprenant les étapes suivantes pour déterminer les distributions de temps de départ et/ou les volumes de trafic (26) identifiés des différents types de trafic:
- Entraînement d'un système d'apprentissage automatique avec plusieurs ensembles de combinaisons de distributions de temps de départ et/ou de volumes de trafic (26) des différents types de trafic, chacun de ces ensembles étant associé à un ensemble de trajectoires temporelles de charge de tronçons de route (3) dans le modèle du réseau de trafic (10), ces tronçons de route (3) correspondant aux tronçons de route de mesure réels;
- Détermination des distributions de temps de départ et/ou des volumes de trafic (26) identifiés par le système d'apprentissage automatique entraîné à partir des courbes temporelles mesurées (23).

10. Procédé selon l'une quelconque des revendications précédentes, comprenant au moins une des étapes suivantes:
- Commande de moyens de gestion du trafic, en particulier de feux de signalisation, en fonction des charges des tronçons de route (3);
- Commande d'appareils de navigation dans des véhicules, en fonction des charges des tronçons de route (3).

11. Procédé selon la revendication 10, comprenant les étapes suivantes:
- Détermination d'au moins une route chargée en tant qu'ensemble cohérent de tronçons de route (3) se succédant dans une direction de déplacement et dont la charge dépasse une certaine mesure;
et au moins une des étapes suivantes
- passage au vert, pendant une durée d'intervalle de vert prédéterminée, de tous les feux de signalisation de l'itinéraire chargé;
- intervention sur la commande des véhicules dans les itinéraires chargés.

12. Procédé selon la revendication 11, dépendant en outre de l'une des revendications 7 à 9, dans lequel, lors de la détermination de l'au moins un itinéraire chargé (11), seule la charge due à un sous-ensemble des différents types de trafic est prise en compte, en particulier seule la charge due à un seul des types de trafic.

13. Procédé selon l'une quelconque des revendications 8 à 12, comprenant les étapes consistant à:
- Saisie d'un lieu de départ et d'un lieu d'arrivée d'un usager réel de la route;
- Détermination d'un itinéraire optimal pour cet usager réel, en tenant compte des charges futures des tronçons (3) du réseau routier;
- transmettre à cet usager réel de la route des instructions de navigation correspondant à cet itinéraire optimal.

14. Système de traitement de données pour la simulation de flux de trafic, le système de traitement de données présentant des moyens pour la mise en oeuvre du procédé selon une ou plusieurs des revendications 1 à 13.

15. Programme informatique de simulation de flux de trafic, qui peut être chargé et exécuté sur une unité de traitement de données et qui, lors de l'exécution, exécute le procédé selon une ou plusieurs des revendications 1 à 13.
